# EUROPEAN PATENT APPLICATION

(11) **EP 4 667 627 A1**
(43) Date of publication of application: **24.12.2025**
(21) Application number: 23922666.5
(22) Date of filing: 15.02.2023
(51) Int. Cl.: C30B 29/16, C30B 11/02

(54) **BETA-DIGALLIUM TRIOXIDE SINGLE CRYSTAL SUBSTRATE, METHOD FOR MANUFACTURING BETA-DIGALLIUM TRIOXIDE SINGLE CRYSTAL, AND METHOD FOR MANUFACTURING BETA-DIGALLIUM TRIOXIDE SINGLE CRYSTAL SUBSTRATE**

(71) Applicant: Sumitomo Electric Industries, Ltd., Osaka-shi, Osaka 541-0041 (JP)
(72) Inventor: HAGI, Yoshiaki, Osaka-shi, Osaka 541-0041 (JP); TANIZAKI, Keisuke, Osaka-shi, Osaka 541-0041 (JP); ISHIKAWA, Yukio, Osaka-shi, Osaka 541-0041 (JP)
(74) Representative: Grünecker Patent- und Rechtsanwälte PartG mbB
(86) International application number: PCT/JP2023/005163
(87) International publication number: WO 2024/171329

(57) **Abstract**

A beta-digallium trioxide single crystal substrate has a circular main surface, and has a diameter of 100 mm or more. The main surface is a (001) plane of a beta-digallium trioxide single crystal; or is a face having an off-angle of more than 0° and 10° or less from the (001) plane of the single crystal, and having an off-direction in a [010] direction of the single crystal or a direction orthogonal to the [010] direction. Second density/first density, which is a ratio between a first density that is a density of line-shaped holes in a first region having a diameter of a length of 0.75D centered at the center of the main surface, and a second density that is a density of line-shaped holes in a second region which is a region outside the first region on the main surface, is larger than 1.0. The second density is 1000 cm⁻² or less. D represents a diameter of the substrate, and a unit of the D is mm. The line-shaped hole has a length of 10 µm or more and 200 µm or less, a width of 0.01 µm or more and 2 µm or less, and a depth of 0.1 µm or more.

## Description

### TECHNICAL FIELD

The present disclosure relates to a beta-digallium trioxide single crystal substrate, a method for manufacturing a beta-digallium trioxide single crystal, and a method for manufacturing a beta-digallium trioxide single crystal substrate.

### BACKGROUND ART

Japanese Patent Laying-Open No. 2016-079080 (PTL 1) and Japanese Patent Laying-Open No. 2017-193466 (PTL 2) disclose a method for manufacturing a digallium trioxide single crystal (hereinafter also referred to as "Ga₂O₃ single crystal") by using a crucible made from a platinum-rhodium alloy, and growing a crystal according to the vertical Bridgeman method. NPL 1 described below discloses that when densities of line-shaped holes have been measured at three predetermined positions on a main surface of a digallium trioxide single crystal substrate (hereinafter also referred to as a "Ga₂O₃ single crystal substrate") having a diameter of 2 inches, the densities of the line-shaped holes have been 3.0×10³ to 5.0×10³ cm⁻². NPL 2 described below discloses that when a Ga₂O₃ single crystal substrate having a diameter of 2 inches was obtained by growing a crystal at a growth rate of 1.1 mm/hour, a density of line-shaped holes of the surface of the substrate has been 50 cm⁻². NPL 3 described below instructs that the number of the line-shaped holes in the Ga₂O₃ single crystal substrate affects characteristics of a Schottky barrier diode.

### CITATION LIST

### PATENT LITERATURE

PTL 1: Japanese Patent Laying-Open No. 2016-079080
PTL 2: Japanese Patent Laying-Open No. 2017-193466

### NON PATENT LITERATURE

NPL 1: Hoshikawa et al., Journal of the Japanese Association for Crystal Growth, Vol. 44, No. 4 (2017), 44-4-03
NPL 2:E. Ohba et al., Japanese Journal of Applied Physics, 55, 1202BF (2016)
NPL 3: O. Ueda et al., Japanese Journal of Applied Physics, 61, 050101 (2022)

### SUMMARY OF INVENTION

A beta-digallium trioxide single crystal substrate according to the present disclosure is a beta-digallium trioxide single crystal substrate having a circular main surface. A diameter of the beta-digallium trioxide single crystal substrate is 100 mm or more. The main surface is a (001) plane of a digallium trioxide single crystal constituting the beta-digallium trioxide single crystal substrate; or alternatively is a face having an off-angle of more than 0° and 10° or less from the (001) plane of the digallium trioxide single crystal, and having an off-direction in a [010] direction of the beta-digallium trioxide single crystal or a direction orthogonal to the [010] direction. Second density/first density, which is a ratio between the first density that is a density of line-shaped holes in a circular first region having a diameter of a length of 0.75D centered at the center of the main surface, and the second density that is a density of line-shaped holes in a second region which is a region outside the first region on the main surface, is larger than 1.0. The second density is 1000 cm⁻² or less. The D represents a diameter of the beta-digallium trioxide single crystal substrate. A unit of the D is mm. The line-shaped hole has a length of 10 µm or more and 200 µm or less, a width of 0.01 µm or more and 2 µm or less, and a depth of 0.1 µm or more. The density of the line-shaped holes in the first region and the density of the line-shaped holes in the second region are each the number of the line-shaped holes per 1 cm², which is determined by forming a virtual grid in which squares each having a side of 10 mm are laid out so that the largest number of squares are arranged in parallel without overlapping with each other, on the main surface, and counting the number of the line-shaped holes present in each of the squares constituting the grid by using a differential interference microscope.

### BRIEF DESCRIPTION OF DRAWINGS

Fig. 1 is an explanatory drawing for explaining a main surface of a beta-Ga₂O₃ single crystal substrate according to the present embodiment as a plan view.
Fig. 2 is an explanatory drawing for explaining a state in which a virtual grid is set by laying squares each having a side of 10 mm, on a main surface of the beta-Ga₂O₃ single crystal substrate of Fig. 1 so that the largest number of squares are arranged in parallel without overlapping with each other, in order to determine the density of line-shaped holes on the main surface.
Fig. 3 is a flowchart showing an example of a method for manufacturing the beta-Ga₂O₃ single crystal substrate according to the present embodiment.
Fig. 4 is a schematic view for explaining a manufacturing apparatus that is used particularly for a first manufacturing method in the method for manufacturing the beta-Ga₂O₃ single crystal substrate according to the present embodiment.
Fig. 5 is a schematic view for explaining a manufacturing apparatus that is used particularly for a second manufacturing method in the method for manufacturing the beta-Ga₂O₃ single crystal substrate according to the present embodiment.
Fig. 6 is a schematic view for explaining a manufacturing apparatus that is used particularly for a third manufacturing method in the method for manufacturing the beta-Ga₂O₃ single crystal substrate according to the present embodiment.

### DETAILED DESCRIPTION

### [Problem to be Solved by the Present Disclosure]

Conventionally, a beta-Ga₂O₃ single crystal substrate has been requested in which a density of line-shaped holes is reduced, from the viewpoint of improving a yield at which a semiconductor device is produced (hereinafter, also referred to as "device yield"). Furthermore, in the beta-Ga₂O₃ single crystal substrate, it is known that so-called a cracking defect often occurs in which the substrate causes cracking or chipping at the time of being cooled after an epitaxial film has been grown on the main surface for the formation of a semiconductor device. For this reason, it is also requested for the beta-Ga₂O₃ single crystal substrate to reduce a probability of formation of the cracking defect (hereinafter, also referred to as "cracking defect rate"). However, PTLs 1 and 2, NPLs 1 to 3 and the like do not refer to the reduction of the cracking defect rate. In addition, the findings concerning the density of the line-shaped holes and the like in NPLs 1 and 2 are based on a Ga₂O₃ single crystal substrate having a diameter of 2 inches. Accordingly, a beta-Ga₂O₃ single crystal substrate having a diameter of 4 inches or more has not been obtained yet, in which the cracking defect rate is reduced while the density of the line-shaped holes is reduced, and the development of such a substrate has been desired.

In view of the points, an object of the present disclosure is to provide; a beta-digallium trioxide single crystal substrate in which the cracking defect rate is reduced; a method for manufacturing a beta-digallium trioxide single crystal; and a method for manufacturing the beta-digallium trioxide single crystal substrate.

### [Advantageous Effect of the Present Disclosure]

According to the present disclosure, it is possible to provide a beta-digallium trioxide single crystal substrate in which the cracking defect rate is reduced, a method for manufacturing a beta-digallium trioxide single crystal, and a method for manufacturing the beta-digallium trioxide single crystal substrate.

### [Summary of Embodiments]

A summary of the embodiments of the present disclosure will be described below. The present inventors have conducted intensive studies in order to solve the problems, and completed the present disclosure. Firstly, the present inventors have paid attention to the identification of the cause why the substrate tends to easily cause cracking when an epitaxial film has been grown on a main surface of the beta-Ga₂O₃ single crystal substrate and the substrate has been then cooled. In particular, the present inventors have studied a relationship between the thermal shrinkage which occurs in the beta-Ga₂O₃ single crystal substrate at the time of the cooling and the distribution of line-shaped holes in the beta-Ga₂O₃ single crystal constituting the substrate. As a result, the present inventors have found that in a case where the density of the line-shaped holes in the central portion of the main surface of the substrate is smaller than the density of the line-shaped holes in the outer peripheral portion, the central portion is thermally shrunk more than the outer peripheral portion, thereby, a compressive stress is generated in the outer peripheral portion, and cracking is less likely to occur. For information, it is known that a crystal having a strong cleavage property such as the beta-Ga₂O₃ single crystal tends to be easily cracked not by a compressive stress but by a tensile stress. From the above, the present inventors have found that the cracking defect rate can be reduced in a beta-Ga₂O₃ single crystal substrate in which the density of the line-shaped holes is larger in the outer peripheral portion than in the central portion of the main surface, and have reached the present disclosure.

Next, embodiments of the present disclosure will be listed and described.
[1] A beta-digallium trioxide single crystal substrate according to one aspect of the present disclosure is a beta-digallium trioxide single crystal substrate having a circular main surface. A diameter of the beta-digallium trioxide single crystal substrate is 100 mm or more. The main surface is a (001) plane of a digallium trioxide single crystal constituting the beta-digallium trioxide single crystal substrate; or alternatively is a face having an off-angle of more than 0° and 10° or less from the (001) plane of the digallium trioxide single crystal, and having an off-direction in a [010] direction of the beta-digallium trioxide single crystal or a direction orthogonal to the [010] direction. Second density/first density, which is a ratio between the first density that is a density of line-shaped holes in a circular first region having a diameter of a length of 0.75D centered at the center of the main surface, and the second density that is a density of line-shaped holes in a second region which is a region outside the first region on the main surface, is larger than 1.0. The second density is 1000 cm⁻² or less. The D represents a diameter of the beta-digallium trioxide single crystal substrate. A unit of the D is mm. The line-shaped hole has a length of 10 µm or more and 200 µm or less, a width of 0.01 µm or more and 2 µm or less, and a depth of 0.1 µm or more. The density of the line-shaped holes in the first region and the density of the line-shaped holes in the second region are each the number of the line-shaped holes per 1 cm², which is determined by forming a virtual grid in which squares each having a side of 10 mm are laid out so that the largest number of squares are arranged in parallel without overlapping with each other, on the main surface, and counting the number of the line-shaped holes present in each of the squares constituting the grid by using a differential interference microscope. A beta-digallium trioxide single crystal substrate having such a feature can reduce the cracking defect rate.
[2] It is preferable that the second density is 1 cm⁻² or more and 100 cm⁻² or less. Thereby, a beta-digallium trioxide single crystal substrate can be provided that has enhanced a performance yield.
[3] It is preferable that the second density/first density is 2.5 or less. Thereby, a beta-digallium trioxide single crystal substrate can be provided in which the cracking defect rate is further reduced.
[4] It is preferable that the beta-digallium trioxide single crystal substrate contains a dopant. It is preferable that the dopant is tin or silicon. It is preferable that an atomic concentration of the dopant is 5.0×10¹⁹ cm⁻³ or less. Thereby, it becomes possible to reduce the cracking defect rate in a beta-digallium trioxide single crystal substrate containing a dopant.
[5] A method for manufacturing a beta-digallium trioxide single crystal according to one aspect of the present disclosure is a method for manufacturing the beta-digallium trioxide single crystal with the use of a vertical boat method, and includes the following steps. Specifically, the manufacturing method includes a step of preparing a single crystal growing apparatus including at least a cylindrical crucible and a heating apparatus that is arranged so as to surround an outer periphery of the crucible; a step of accommodating a seed crystal in a bottom portion of the crucible, and accommodating a massive digallium trioxide bulk body in an upper portion above the seed crystal in the crucible; a step of heating the crucible with the heating apparatus to melt the digallium trioxide bulk body and a part of the seed crystal, thereby obtaining a digallium trioxide melt, and contacting the digallium trioxide melt with a remaining portion of the seed crystal; and a step of obtaining the beta-digallium trioxide single crystal by growing a crystal on the remaining portion of the seed crystal from the digallium trioxide melt. The crucible is formed from a platinum-rhodium alloy. The step of obtaining the beta-digallium trioxide single crystal includes a step of inserting a stirring rod formed from a platinum-rhodium alloy into the digallium trioxide melt and growing the crystal while stirring the digallium trioxide melt with the stirring rod. According to the manufacturing method having such a feature, the beta-digallium trioxide single crystal for manufacturing the beta-digallium trioxide single crystal substrate can be obtained in which the cracking defect rate is reduced.
[6] A method for manufacturing a beta-digallium trioxide single crystal according to one aspect of the present disclosure is a method for manufacturing the beta-digallium trioxide single crystal with the use of a vertical boat method, and includes the following steps. Specifically, the manufacturing method includes a step of preparing a single crystal growing apparatus including at least a cylindrical crucible and a heating apparatus that is arranged so as to surround an outer periphery of the crucible; a step of accommodating a seed crystal in a bottom portion of the crucible, and accommodating a massive digallium trioxide bulk body in an upper portion above the seed crystal in the crucible; a step of heating the crucible with the heating apparatus to melt the digallium trioxide bulk body and a part of the seed crystal, thereby obtaining a digallium trioxide melt, and contacting the digallium trioxide melt with a remaining portion of the seed crystal; and a step of obtaining the beta-digallium trioxide single crystal by growing a crystal on the remaining portion of the seed crystal from the digallium trioxide melt. The crucible is formed from a platinum-rhodium alloy. The step of obtaining the beta-digallium trioxide single crystal includes a step of inserting a hollow tube formed from a platinum-rhodium alloy into the digallium trioxide melt and growing the crystal while blowing an inert gas into the digallium trioxide melt through the hollow tube. According to the manufacturing method having such a feature, the beta-digallium trioxide single crystal for manufacturing the beta-digallium trioxide single crystal substrate can be obtained in which the cracking defect rate is reduced.
[7] It is preferable that the step of obtaining the beta-digallium trioxide single crystal includes a step of stirring the digallium trioxide melt with the hollow tube. Thereby, the beta-digallium trioxide single crystal for manufacturing the beta-digallium trioxide single crystal substrate can be obtained in which the cracking defect rate is further reduced.
[8] In the manufacturing method, it is preferable that the single crystal growing apparatus is accommodated in a pressure vessel. Furthermore, it is preferable that the manufacturing method includes a step of repeating an operation of reducing a pressure in the pressure vessel from 1 atm and then returning the pressure to the 1 atm, three or more times, after the step of contacting the digallium trioxide melt with the remaining portion of the seed crystal and before the step of obtaining the beta-digallium trioxide single crystal. Thereby, the beta-digallium trioxide single crystal for manufacturing the beta-digallium trioxide single crystal substrate can be obtained in which the cracking defect rate is further reduced.
[9] A method for manufacturing a beta-digallium trioxide single crystal substrate according to one aspect of the present disclosure includes a step of processing the beta-digallium trioxide single crystal obtained by the method for manufacturing the beta-digallium trioxide single crystal to obtain a beta-digallium trioxide single crystal substrate having a circular main surface. According to the manufacturing method having such a feature, a beta-digallium trioxide single crystal substrate can be obtained in which the cracking defect rate is reduced.
[10] In the beta-digallium trioxide single crystal substrate, it is preferable that the second density is 1 cm⁻² or more and 90 cm⁻² or less. It is preferable that the second density/first density is 1.1 or more and 2 or less. It is preferable that the beta-digallium trioxide single crystal substrate contains a dopant. It is preferable that the dopant is tin. It is preferable that an atomic concentration of the dopant is 5.0×10¹⁹ cm⁻³ or less. Thereby, in a beta-digallium trioxide single crystal substrate containing tin as the dopant, the performance yield can be enhanced, and the cracking defect rate can be reduced.

### [Details of Embodiments]

One embodiment according to the present disclosure (hereinafter also referred to as "the present embodiment") will be described below in further detail, but the present disclosure is not limited thereto. The following description may be made with reference to a drawing, and an identical or corresponding element in the present specification and the drawing is denoted by the same reference sign; and the same description thereof will not be repeated. Furthermore, in the drawings, a scale of each component is appropriately adjusted for easy understanding of the components, and the scale of each component illustrated in the drawings does not necessarily coincide with the scale of an actual component.

In the present specification, the expression of a range in the format "A to B" means the upper limit and the lower limit of the range (in other words, A or more and B or less), and when no unit is written in A and a unit is only written in B, the unit for A and the unit for B are the same. Furthermore, in the present specification, when a compound or the like is represented by a chemical formula, if the atomic ratio is not particularly limited, the chemical formula shall include all conventionally known atomic ratios, and should not necessarily be limited only to those within the stoichiometric range.

In the present specification, the "main surface" of the beta-digallium trioxide single crystal substrate means both of two circular faces of the beta-digallium trioxide single crystal substrate. When at least one of the two faces satisfies the scope of the claims according to the present disclosure, the beta-digallium trioxide single crystal substrate belongs to the technical scope of the present disclosure. In addition, in the present specification, the term "face" used in the term "in face" means a "main surface". Furthermore, when a diameter of the beta-digallium trioxide single crystal substrate is described as "100 mm", the diameter means approximately 100 mm (about 95 to 105 mm), or means 4 inches. When the diameter is described as "150 mm", the diameter means approximately 150 mm (about 145 to 155 mm), or means 6 inches. For information, the diameter can be measured with the use of a conventionally known outer-diameter measuring instrument such as a vernier caliper.

In the present specification, the "line-shaped hole" means an oxygen hole formed in the beta-digallium trioxide single crystal in a predetermined size, when the single crystal has been grown according to the vertical boat method. The "predetermined size" of the line-shaped hole means a length of 0 µm or more and 200 µm or less, a width of 0.01 µm or more and 2 µm or less, and a depth of 0.1 µm or more. The "line-shaped hole" is assumed to be generated by such a mechanism that the digallium trioxide is decomposed into digallium oxide (gas) and oxygen (gas) in the digallium trioxide melt which will be described later, due to high temperature, and these gases adsorb to a solid-liquid interface of the digallium trioxide or an interface between an inner surface of the crucible and the digallium trioxide melt (in other words, the inner surface of the crucible). This is because it is assumed that when the digallium trioxide melt solidifies, the gases cannot be separated from the digallium trioxide melt, are incorporated into the crystal in a form of voids, and thereby forming line-shaped holes.

In the present specification, the "device yield" means a yield obtained by multiplying a processing yield that indicates a ratio at which various semiconductor devices can be obtained from the beta-digallium trioxide single crystal substrate without causing cracking, chipping or the like at the time of processing, by a performance yield that indicates a ratio at which the semiconductor device obtained from the substrate can satisfy a required predetermined performance. The "performance yield" of the "device yield" can be evaluated by determining a leakage current defect rate of a Schottky barrier diode which will be described later. The "leakage current defect rate of the Schottky barrier diode" can be expressed by percentage. In the present specification, the "cracking defect rate" can be represented by a rate at which cracking, chipping or the like occurs in the beta-digallium trioxide single crystal substrate, in a series of steps from a step of performing epitaxial growth for forming a semiconductor layer or the like on the substrate, to a step of producing a semiconductor device. The "cracking defect rate" can be expressed by percentage. The "cracking defect rate" is a factor that determines the "processing yield" in the "device yield", and satisfies a relationship of 100% - "cracking defect rate" = "processing yield". In the present specification, the "device yield" shall be represented by an device yield index that is obtained by multiplying the "cracking defect rate" by the "leakage current defect rate of the Schottky barrier diode". For information, the smaller the value of the "device yield index" is, the more satisfactorily the "device yield" can be evaluated.

In the crystallographic description in the present specification, an individual orientation is indicated by [ ], a family of orientations are indicated by < >, an individual plane is indicated by ( ), and a family of the plane is indicated by { }. In addition, a negative crystallographic index is usually represented by adding a "- (bar)" above a number, but in the present specification, a negative sign is added before the number.

### [Digallium Trioxide Single Crystal Substrate]

The beta-digallium trioxide single crystal substrate (beta-Ga₂O₃ single crystal substrate) according to the present embodiment is a beta-Ga₂O₃ single crystal substrate having a circular main surface. A diameter of the beta-Ga₂O₃ single crystal substrate is 100 mm or more. The main surface is a (001) plane of the beta-digallium trioxide single crystal (beta-Ga₂O₃ single crystal) constituting the beta-Ga₂O₃ single crystal substrate; or alternatively is a face having an off-angle of more than 0° and 10° or less from the (001) plane of the beta-Ga₂O₃ single crystal; and having an off-direction in a [010] direction of the beta-digallium trioxide single crystal or a direction orthogonal to the [010] direction. Second density/first density, which is a ratio between the first density that is a density of line-shaped holes in a circular first region having a diameter of a length of 0.75D centered at the center of the main surface, and a second density that is a density of line-shaped holes in the second region which is a region outside the first region on the main surface, is larger than 1.0. The second density is 1000 cm⁻² or less. The D represents a diameter of the beta-Ga₂O₃ single crystal substrate. A unit of the D is mm. The line-shaped hole has a length of 10 µm or more and 200 µm or less, a width of 0.01 µm or more and 2 µm or less, and a depth of 0.1 µm or more. The density of the line-shaped holes in the first region and the density of the line-shaped holes in the second region are each the number of the line-shaped holes per 1 cm², which is determined by forming a virtual grid in which squares each having a side of 10 mm are laid out so that the largest number of squares are arranged in parallel without overlapping with each other, on the main surface, and counting the number of the line-shaped holes present in each of the squares constituting the grid by using a differential interference microscope. A beta-Ga₂O₃ single crystal substrate having such a feature can reduce the cracking defect rate.

The present inventors assume that the reason why the cracking defect rate can be reduced in the beta-Ga₂O₃ single crystal substrate is as follows. For information, the following assumption is described on a presumption that the main surface of the beta-Ga₂O₃ single crystal substrate is a face having a strong cleavage tendency (for example, a (001) plane of the beta-Ga₂O₃ single crystal constituting the substrate; or alternatively a face having an off-angle of more than 0° and 10° or less from the (001) plane of the single crystal, and having an off-direction in a [010] direction of the single crystal or a direction orthogonal to the [010] direction). This is because a crystal having a strong cleavage plane has such a feature as to generally tend to be easily cracked when having been pulled, but receive little influence on cracking even when having been compressed.

The beta-Ga₂O₃ single crystal substrate is cooled after an epitaxial film has been grown on the main surface thereof, in a process of producing a semiconductor device from the substrate. At this time, the beta-Ga₂O₃ single crystal substrate is in a state where the whole surface thereof is constrained by the epitaxial film, and different thermal stresses are generated at various positions in the face so as to reflect the distribution of the densities of the line-shaped holes in the beta-Ga₂O₃ single crystal constituting the substrate. Specifically, in a case where the main surface is divided into a first region having a circular shape centered on the center of the main surface and a second region which is region outside the first region, when the density of the line-shaped holes in the first region is higher than the density of the line-shaped holes in the second region, the second region thermally more shrinks compared to the first region. As a result, there is a tendency that a tensile stress is generated in the second region corresponding to the outer peripheral portion of the substrate, and the substrate tends to be easily cracked. On the other hand, when the density of the line-shaped holes in the first region is smaller than the density of the line-shaped holes in the second region as in the beta-Ga₂O₃ single crystal substrate according to the present embodiment, the first region is thermally shrunk more than the second region. In this case, the compressive stress is generated in the second region, and accordingly, it is assumed that an adverse effect on cracking is small. In addition, a tensile stress is generated in the first region because the first region causes thermal shrinking more compared to the second region, and it is assumed that there is little possibility that the tensile stress in the first region develops into a crack in the substrate, because the first region corresponds to the central portion of the substrate. For information, the thermal stress is generated in the substrate also at the time when the temperature rises when the epitaxial film is grown on the main surface, but the whole surface of the main surface is not restrained by the epitaxial film, and accordingly, it is assumed that there is little possibility that cracking of the substrate is generated due to the thermal stress at the time of the temperature rise.

From the above, it is assumed that the beta-Ga₂O₃ single crystal substrate according to the present embodiment can reduce the cracking defect rate, which is an aspect in which the density of the line-shaped holes in the first region is smaller than the density of the line-shaped holes in the second region. Furthermore, in the beta-Ga₂O₃ single crystal substrate according to the present embodiment, the second density representing the density of the line-shaped holes in the second region is 1000 cm⁻² or less as described above, and accordingly, the density of the line-shaped holes in the whole surface of the substrate is also evaluated to be small.

### <Diameter>

A diameter of the beta-Ga₂O₃ single crystal substrate is 100 mm or more. In particular, it is preferable that the diameter of the beta-Ga₂O₃ single crystal substrate is 100 mm or more and 152.4 mm or less. It is preferable for the beta-Ga₂O₃ single crystal substrate having a diameter of 100 mm or more and 152.4 mm or less to have specifically the diameter of 100 mm or 152.4 mm, and in other words, is preferable to have the diameter of 4 inches or 6 inches. Thereby, the cracking defect rate can be reduced in the beta-Ga₂O₃ single crystal substrate having a large diameter of 100 mm or more and 152.4 mm or less. Here, the diameter of the beta-Ga₂O₃ single crystal substrate shall be determined, even if the main surface has a shape that is not geometrically circular due to the influence of an orientation flat (hereinafter also referred to as "OF"), an index flat (hereinafter also referred to as "IF") or the like, on the basis of a circular shape before the OF, IF or the like is formed. In addition, the diameter of the beta-Ga₂O₃ single crystal substrates can be measured with the use of a conventionally known outer-diameter measuring instrument such as the vernier caliper, as in the above. In addition, a definition of the "circular shape" will be described later which represents the shape of the main surface in the present specification.

### <Main surface>

### (Circular shape)

The beta-Ga₂O₃ single crystal substrate according to the present embodiment has the circular main surface as described above. In the present specification, the "circular shape" representing the shape of the main surface includes a geometrical circular shape, and also includes a shape in the case where the main surface does not form the geometrical circular shape, due to formation of at least any one of a notch, OF and IF in the outer periphery of the main surface. Here, the "shape in the case where the main surface does not form a geometrical circular shape" means a shape in the case where among line segments that extend from an arbitrary point on the outer periphery of the main surface to the center of the main surface, a length of a line segment that extends from an arbitrary point on the notch, OF and IF to the center of the main surface becomes short. Furthermore, the "shape in the case where the main surface does not form a geometrical circular shape" includes a shape in the case where all the lengths of line segments that extend from arbitrary points on the outer periphery of the main surfaces to the center of the main surface are not necessarily identical, due to the shape of the beta-Ga₂O₃ single crystal which is a raw material of the beta-Ga₂O₃ single crystal substrate. In this case, the center of the main surface shall refer to the position of the center of gravity; and the diameter of the beta-Ga₂O₃ single crystal substrate shall refer to the longest line segment among line segments that extend from an arbitrary point on the outer periphery of the beta-Ga₂O₃ single crystal substrate to another point on the outer periphery through the center of the main surface.

### ((001) Plane of beta-Ga₂O₃ single crystal)

The main surface is a (001) plane of the beta-Ga₂O₃ single crystal constituting the beta-Ga₂O₃ single crystal substrate, or a face having an off-angle of more than 0° and 10° or less from the (001) plane of the beta-Ga₂O₃ single crystal, and having an off-direction in a [010] direction of the beta-Ga₂O₃ single crystal or a direction orthogonal to the [010] direction. The (001) plane of the beta-Ga₂O₃ single crystal is known as a strong cleavage plane next to a (100) plane, and has such a feature as to be easily cracked when being pulled, as described above. However, in the beta-Ga₂O₃ single crystal substrate, a compressive stress is generated in the second region corresponding to the outer peripheral portion of the substrate and a tensile stress is not generated, at the time of cooling after the epitaxial film has been grown, which tends to easily cause cracks in a process of producing the semiconductor device. Because of this, the beta-Ga₂O₃ single crystal substrate resists being cracked, and as a result, the cracking defect rate can be reduced.

In the present specification, the crystal plane of the main surface has an accuracy error of ±0.5°. For example, when the main surface is said to be the "(001) plane" of the beta-Ga₂O₃ single crystal, this means that the main surface may be a (001) just plane, or the main surface may be a face having an off-angle of -0.5 to +0.5° from the (001) plane. The off-angle and off-direction from the (001) plane on the main surface of the beta-Ga₂O₃ single crystal substrate can be measured with the use of a conventionally known crystal orientation measuring apparatus (for example, trade name (product number): "FSASIII" manufactured by Rigaku Holdings Corporation).

### (Line-shaped hole)

As described above, in the beta-Ga₂O₃ single crystal substrate, second density/first density, which is a ratio between the first density that is a density of line-shaped holes in a circular first region having a diameter of a length of 0.75D centered at the center of the main surface, and the second density that is a density of line-shaped holes in a second region which is a region outside the first region on the main surface, is larger than 1.0. The second density is 1000 cm⁻² or less. The D represents a diameter of the beta-Ga₂O₃ single crystal substrate. A unit of the D is mm. The line-shaped hole has a length of 10 µm or more and 200 µm or less, a width of 0.01 µm or more and 2 µm or less, and a depth of 0.1 µm or more. The density of the line-shaped holes in the first region and the density of the line-shaped holes in the second region are each the number of the line-shaped holes per 1 cm², which is determined by forming a virtual grid in which squares each having a side of 10 mm are laid out so that the largest number of squares are arranged in parallel without overlapping with each other, on the main surface, and counting the number of the line-shaped holes present in each of the squares constituting the grid by using a differential interference microscope.

The line-shaped hole has a length of 10 µm or more and 200 µm or less, a width of 0.01 µm or more and 2 µm or less, and a depth of 0.1 µm or more, as described above. The line-shaped hole is an oxygen hole formed in the single crystal in a process of growing the beta-Ga₂O₃ single crystal, as described above. When the line-shaped hole has the above-mentioned size, it becomes a structural feature of the beta-Ga₂O₃ single crystal substrate which can affect both of the "performance yield" and the "processing yield" constituting the above-mentioned device yield. When the line-shaped hole has a length of less than 10 µm, a width of less than 0.01 µm, or a depth of less than 0.1 µm, there is a possibility that the line-shaped hole does not affect or substantially does not affect both of the "performance yield" and the "processing yield" constituting the above-mentioned device yield. On the other hand, it is difficult to conceive that the line-shaped hole in the beta-Ga₂O₃ single crystal substrate has a length exceeding 200 µm or a width exceeding 2 µm. This is because the line-shaped hole having such a size can be found by visual observation or the like at a stage of having manufactured the beta-Ga₂O₃ single crystal by a predetermined manufacturing method, and accordingly, such a beta-Ga₂O₃ single crystal is not usually selected as a material for manufacturing the beta-Ga₂O₃ single crystal substrate. The upper limit of the depths of the line-shaped holes is not particularly limited, and can be set to 100 µm, for example.

### 1) First region and second region

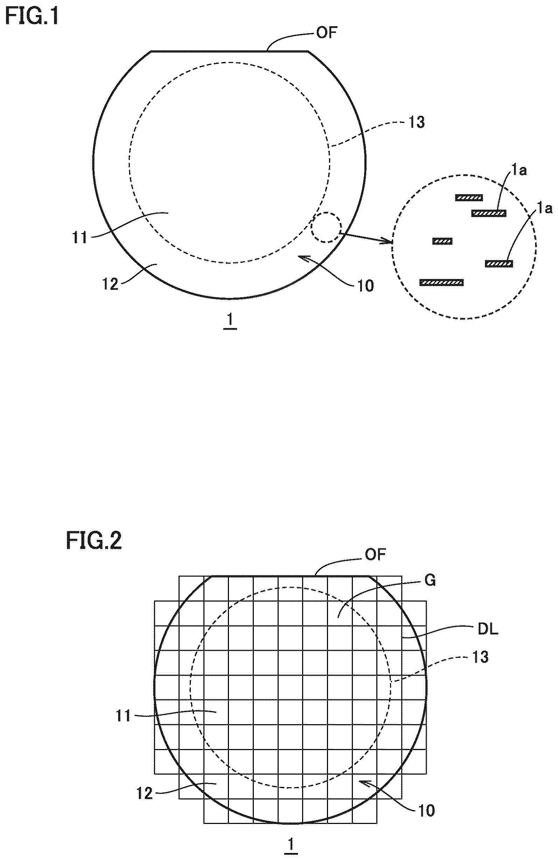

Fig. 1 is an explanatory drawing for explaining a main surface of a beta-Ga₂O₃ single crystal substrate according to the present embodiment as a plan view. As is shown in Fig. 1, a main surface 10 of a beta-Ga₂O₃ single crystal substrate 1 can be divided into a first region 11 including the center of the substrate and a second region 12 surrounding the outer periphery of first region 11. First region 11 is specifically circular in shape and has a length of a diameter of 0.75D, which is centered on the center of main surface 10, as described above. Second region 12 is a region outside of first region 11 on main surface 10. The D represents the diameter of beta-Ga₂O₃ single crystal substrate 1. A unit of the D is mm. Accordingly, when the diameter of beta-Ga₂O₃ single crystal substrate 1 is 100 mm, first region 11 becomes a circular region having a diameter of a length of 75 mm centered on the center of main surface 10. Second region 12 specifically becomes an annular region surrounding the outer periphery of first region 11 with a width of 25 mm. When the diameter of beta-Ga₂O₃ single crystal substrate 1 is 150 mm, first region 11 becomes a circular region having a diameter of a length of 112.5 mm centered on the center of main surface 10. In this case, second region 12 becomes an annular region surrounding the outer periphery of first region 11 with a width of 37.5 mm. In Fig. 1, the orientation flat OF of beta-Ga₂O₃ single crystal substrate 1 is provided in a direction parallel to the [010] direction of the beta-Ga₂O₃ single crystal. In addition, in Fig. 1, for convenience of explanation, a boundary 13 between first region 11 and second region 12 is indicated by a broken line.

### 2) First density and second density

The first density is a density of line-shaped holes 1a in first region 11. The second density is a density of line-shaped holes 1a in second region 12. The second density/first density, which is the ratio between the first density and the second density in beta-Ga₂O₃ single crystal substrate 1, is larger than 1.0. In addition, the second density is 1000 cm⁻² or less. Accordingly, the first density is less than 1000 cm⁻². In addition, the method for measuring the number of line-shaped holes 1a and the density thereof will be described later.

It is preferable that the second density/first density is 2.5 or less. It is more preferable that the second density/first density is 1.1 or more and 2.0 or less. Thereby, it becomes possible to provide a beta-Ga₂O₃ single crystal substrate in which the cracking defect rate is further reduced. In addition, it is preferable that the second density is 1 cm⁻² or more and 100 cm⁻² or less. It is more preferable that the second density is 1 cm⁻² or more and 90 cm⁻² or less. Thereby, it becomes possible to provide a beta-Ga₂O₃ single crystal substrate in which the cracking defect rate is further reduced. It is preferable that the first density is 0.1 cm⁻² or more and less than 90 cm⁻².

### 3) Method for measuring density of line-shaped holes

A measuring method for determining the density of line-shaped holes 1a will be briefly described below. Fig. 2 is an explanatory drawing that explains a state in which a virtual grid is set by laying squares each having a side of 10 mm, on the main surface of the beta-Ga₂O₃ single crystal substrate of Fig. 1 so that the largest number of squares are arranged in parallel without overlapping with each other, in order to determine the density of line-shaped holes on the main surface. As is shown in Fig. 2, a virtual grid G is set by laying out squares each having a side of 10 mm on main surface 10 so that the largest number of squares are arranged in parallel without overlapping with each other, with the use of lines DL for division into a grid pattern. The density of line-shaped holes 1a in first region 11 and the density of line-shaped holes 1a in second region 12 are the numbers of line-shaped holes 1a per 1 cm², which are determined by counting the numbers of line-shaped holes 1a present in the squares constituting grid G by using a differential interference microscope. For the measuring method, for example, a differential interference microscope (trade name (model number): "LV - 150", manufactured by Nikon Corporation) can be used. For information, boundary 13 between first region 11 and second region 12 is indicated by the broken line, also in Fig. 2, for convenience of explanation.

The measuring method for determining the density of line-shaped holes 1a is specifically as follows. Firstly, beta-Ga₂O₃ single crystal substrate 1 is obtained, for example, by following a manufacturing method which will be described later. Subsequently, as shown in Fig. 2, a grid G is set on main surface 10 of beta-Ga₂O₃ single crystal substrate 1, by lines DL for dividing main surface 10 into a grid pattern being used. This grid G is formed by laying out squares each having a side of 10 mm on main surface 10 so that the largest number of squares are arranged in parallel without overlapping with each other. Furthermore, each of the squares constituting grid G is observed by the differential interference microscope, and thereby, the number of line-shaped holes 1a is counted which have appeared in one visual field of the differential interference microscope. In this case, the observation with the differential interference microscope is performed at a magnification of 10 times. Thereby, one visual field of the differential interference microscope becomes a size of 10 mm × 10 mm, which corresponds to the size of the square. Because of this, the number of line-shaped holes 1a per visual field is determined as the density of line-shaped holes 1a per square constituting virtual grid G. As for line-shaped holes 1a, only line-shaped holes 1a are counted which have been observed to have the above-mentioned lengths, widths and depths. In addition, the depth of a line-shaped hole 1a can be determined by shifting a focal position of the differential interference microscope in the depth direction.

Finally, the number of line-shaped holes 1a counted for each square constituting virtual grid G is converted into the number per 1 cm². Thereby, the density of line-shaped holes 1a in each of the squares constituting grid G set in first region 11 and the density of line-shaped holes 1a in each of the squares constituting grid G set in second region 12 are calculated. Subsequently, the sum of the densities of line-shaped holes 1a in first region 11 is divided by the number of the squares constituting grid G set in first region 11, and thereby the first density is determined. Similarly, the sum of the densities of line-shaped holes 1a in second region 12 is divided by the number of the squares constituting grid G set in second region 12, and thereby the second density is determined. In the present specification, "laying out the largest number of squares in parallel without overlapping with each other" on the main surface means that, when the squares are laid in parallel without overlapping with each other on main surface 10, if the outside of main surface 10 is included in the square, the square shall be excluded as an element constituting virtual grid G. This is for determining the second density as a more appropriate and reasonable value. Furthermore, when both first region 11 and second region 12 of main surface 10 are included in the square, line-shaped hole 1a counted in the square shall be regarded as line-shaped hole 1a in second region 12. This is for appropriately evaluating the relationship between a ratio between the first density and the second density (second density/first density) and the cracking defect rate in beta-Ga₂O₃ single crystal substrate 1.

### <Dopant>

It is preferable that the beta-Ga₂O₃ single crystal substrate according to the present embodiment contains a dopant. It is preferable that the dopant is tin (Sn) or silicon (Si). It is preferable that the atomic concentration of the dopant is 5.0×10¹⁹ cm⁻³ or less. Thereby, it becomes possible to impart characteristics of n-type (electron-donating) as a conductivity type to the beta-Ga₂O₃ single crystal substrate, and also to reduce the cracking defect rate in the beta-Ga₂O₃ single crystal substrate containing the dopant.

The atomic concentration of Sn or Si in the beta-Ga₂O₃ single crystal substrate is measured with the use of glow-discharge mass spectrometry (GDMS). In the case where the beta-Ga₂O₃ single crystal substrate is obtained from the beta-Ga₂O₃ single crystal obtained by a manufacturing method for the beta-Ga₂O₃ single crystal as will be described later, the beta-Ga₂O₃ single crystal substrate containing the dopant can be obtained by addition of a predetermined amount of the dopant to a crucible together with a raw material such as a digallium trioxide bulk body (hereinafter also referred to as a "Ga₂O₃ bulk body"). It is more preferable that the dopant is Sn. It is more preferable that the atomic concentration of the dopant is 5.0×10¹⁷ cm⁻³ or more and 4.0×10¹⁹ cm⁻³ or less.

### [Method for manufacturing beta-digallium trioxide single crystal]

It is preferable that the method for manufacturing a beta-digallium trioxide single crystal (beta-Ga₂O₃ single crystal) according to the present embodiment is, for example, a method for manufacturing a beta-Ga₂O₃ single crystal which constitutes the beta-Ga₂O₃ single crystal substrate having a circular main surface described above. A method for manufacturing the beta-Ga₂O₃ single crystal is a method for manufacturing a Ga₂O₃ single crystal with the use of a vertical boat method, and can include the following steps. Specifically, the manufacturing method includes a step of preparing a single crystal growing apparatus (hereinafter, also referred to as a "Ga₂O₃ single crystal growing apparatus") including at least a cylindrical crucible and a heating apparatus that is arranged so as to surround an outer periphery of the crucible; a step of accommodating a seed crystal in a bottom portion of the crucible, and accommodating a massive digallium trioxide bulk body (Ga₂O₃ bulk body) in an upper portion above the seed crystal in the crucible; a step of heating the crucible with the heating apparatus to melt the Ga₂O₃ bulk body and a part of the seed crystal, thereby obtaining a digallium trioxide melt (Ga₂O₃ melt), and also contacting the Ga₂O₃ melt with a remaining portion of the seed crystal; and a step of obtaining the beta-Ga₂O₃ single crystal by growing a crystal on the remaining portion of the seed crystal from the Ga₂O₃ melt. The crucible is formed from a platinum-rhodium alloy.

In particular, in a first manufacturing method which is one aspect of the method for manufacturing the beta-Ga₂O₃ single crystal and will be described later, the step of obtaining the beta-Ga₂O₃ single crystal includes a step of inserting a stirring rod formed from a platinum-rhodium alloy into the Ga₂O₃ melt and growing the crystal while stirring the Ga₂O₃ melt with the stirring rod. In a second manufacturing method which is another aspect of the method for manufacturing the beta-Ga₂O₃ single crystal and will be described later, the step of obtaining the beta-Ga₂O₃ single crystal includes a step of inserting a hollow tube formed from a platinum-rhodium alloy into the Ga₂O₃ melt and growing the crystal while blowing an inert gas into the Ga₂O₃ melt through the hollow tube. In addition, a third manufacturing method which is still another aspect of the method for manufacturing the beta-Ga₂O₃ single crystal and will be described later includes: incorporating the following features into the single crystal growing apparatus or the like, and then performing the first manufacturing method or the second manufacturing method. Specifically, in the third manufacturing method, the single crystal growing apparatus is accommodated in a pressure vessel. Furthermore, the manufacturing method includes a step of repeating an operation of reducing the pressure in the pressure vessel from 1 atm and then returning the pressure to the 1 atm, three or more times, after the step of contacting the Ga₂O₃ melt with the remaining portion of the seed crystal and before the step of obtaining the beta-Ga₂O₃ single crystal. According to the method for manufacturing the beta-Ga₂O₃ single crystal having such a feature, the beta-Ga₂O₃ single crystal which can be used for forming the beta-Ga₂O₃ single crystal substrate can be obtained in which the cracking defect rate is reduced.

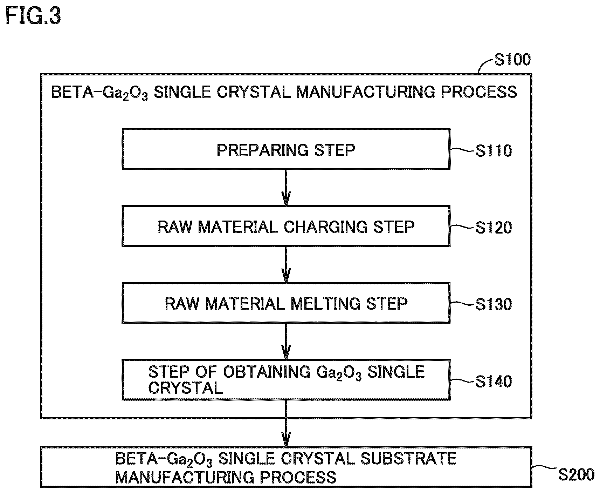

Fig. 3 is a flowchart showing one example of a method for manufacturing a beta-Ga₂O₃ single crystal substrate according to the present embodiment. It is preferable that the method for manufacturing a beta-Ga₂O₃ single crystal according to the present embodiment is included in the method for manufacturing the beta-Ga₂O₃ single crystal substrate as, for example, a beta-Ga₂O₃ single crystal manufacturing process S100, which is shown in the flowchart of Fig. 3. According to Fig. 3, the method for manufacturing the beta-Ga₂O₃ single crystal substrate according to the present embodiment includes beta-Ga₂O₃ single crystal manufacturing process S100, and a beta-Ga₂O₃ single crystal substrate manufacturing process S200. Beta-Ga₂O₃ single crystal manufacturing process S100 includes a step of preparing a Ga₂O₃ single crystal growing apparatus including at least a cylindrical crucible and a heating apparatus that is arranged so as to surround the outer periphery of the crucible (first step: a preparing step S110). In preparing step S110, it is preferable that a seed crystal, a massive Ga₂O₃ bulk body, and solid boron oxide (B₂O₃) are also prepared, in addition to the Ga₂O₃ single crystal growing apparatus. Beta-Ga₂O₃ single crystal manufacturing process S100 includes a step of accommodating the seed crystal in the bottom portion of the crucible, and accommodating the Ga₂O₃ bulk body in an upper portion above the seed crystal in the crucible (second step: a raw material charging step S120). In raw material charging step S120, it is preferable that the Ga₂O₃ bulk body is accommodated in the upper portion above the seed crystal in the crucible, and then the solid B₂O₃ is accommodated on the Ga₂O₃ bulk body. Beta-Ga₂O₃ single crystal manufacturing process S100 includes a step of heating the crucible with the heating apparatus to melt the Ga₂O₃ bulk body and a part of the seed crystal, thereby obtaining a Ga₂O₃ melt, and contacting the Ga₂O₃ melt with the remaining portion of the seed crystal (third step: a raw material melting step S130). It is preferable that raw material melting step S130 includes a step of changing the B₂O₃ into a liquid. Beta-Ga₂O₃ single crystal manufacturing process S100 further includes a step of obtaining a beta-Ga₂O₃ single crystal by growing a crystal from the Ga₂O₃ melt on the remaining portion of the seed crystal (fourth step: a Ga₂O₃ single crystal growing step S140).

The present inventors have paid attention to controlling the density distribution of line-shaped holes in the beta-Ga₂O₃ single crystal, when the single crystal is grown with the use of the vertical boat method, which constitutes the beta-Ga₂O₃ single crystal substrate. In particular, the present inventors have conceived to insert a stirring rod formed from a platinum-rhodium alloy into the Ga₂O₃ melt in the crucible, and stir the Ga₂O₃ melt with the stirring rod, in the step of obtaining the beta-Ga₂O₃ single crystal. Alternatively, the present inventors have conceived to insert a hollow tube formed from a platinum-rhodium alloy into the Ga₂O₃ melt in the crucible and blow an inert gas into the Ga₂O₃ melt through the hollow tube. Thereby, the present inventors have found that when a beta-Ga₂O₃ single crystal is manufactured by the above method and a beta-Ga₂O₃ single crystal substrate is manufactured from the beta-Ga₂O₃ single crystal, the density of line-shaped holes in the central portion of the main surface of the substrate becomes smaller than the density of line-shaped holes in the outer peripheral portion. In this case, the substrate resists being cracked when being cooled after the epitaxial film has been grown on the main surface of the beta-Ga₂O₃ single crystal substrate, as described above. From the above, the present inventors have arrived at a method for manufacturing a beta-Ga₂O₃ single crystal, which can constitute a beta-Ga₂O₃ single crystal substrate in which the cracking defect rate is reduced.

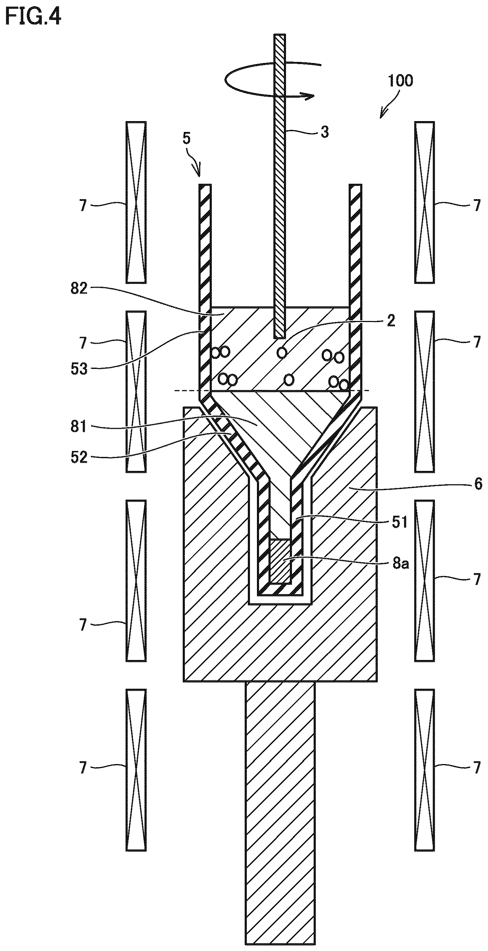

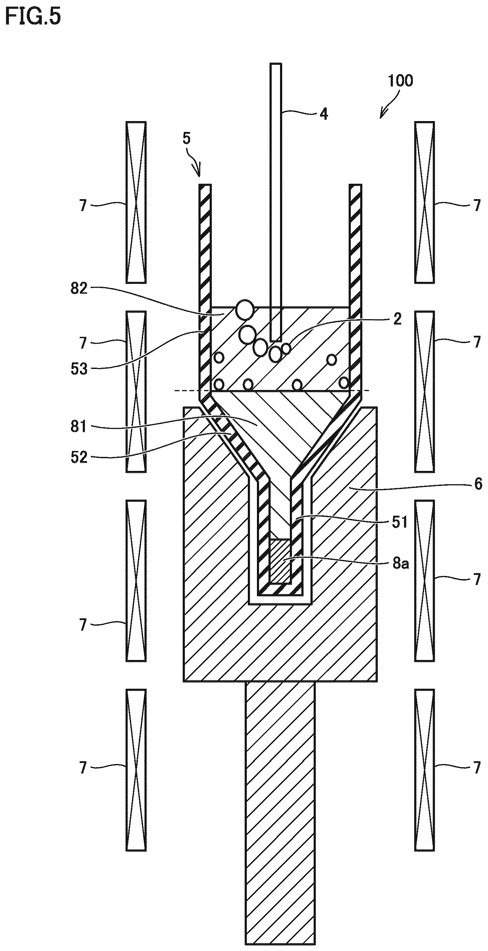

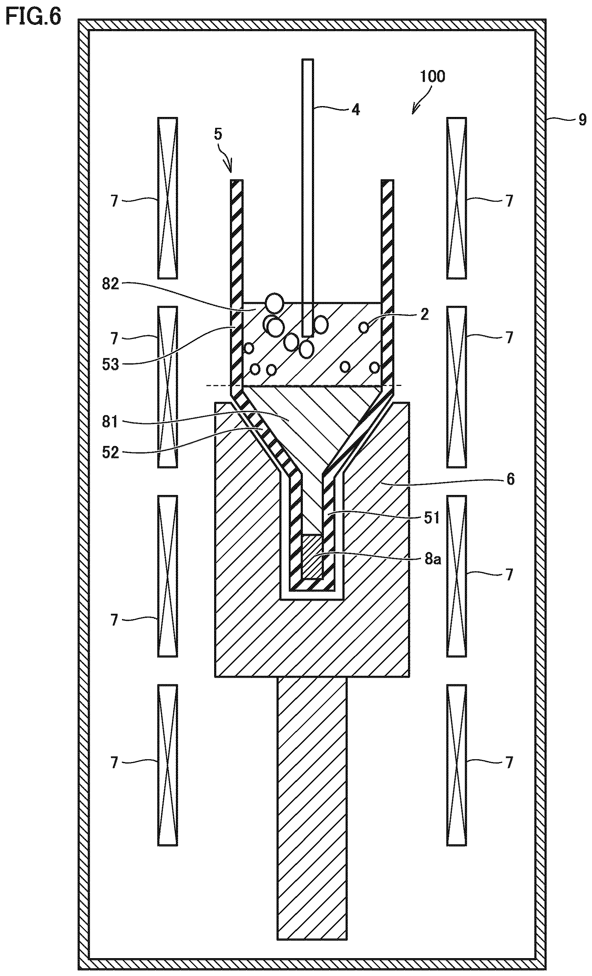

Summaries of the Ga₂O₃ single crystal growing apparatus and beta-Ga₂O₃ single crystal manufacturing process S 100 will be described below with reference to Figs 3 to 6, respectively. Fig. 4 is a schematic view for explaining a manufacturing apparatus that is used particularly for the first manufacturing method in the method for manufacturing the beta-Ga₂O₃ single crystal substrate according to the present embodiment. Fig. 5 is a schematic view for explaining a manufacturing apparatus that is used particularly for the second manufacturing method in the method for manufacturing the beta-Ga₂O₃ single crystal substrate according to the present embodiment. Fig. 6 is a schematic view for explaining a manufacturing apparatus that is used particularly for a third manufacturing method in the method for manufacturing the beta-Ga₂O₃ single crystal substrate according to the present embodiment. In the method for manufacturing a beta-Ga₂O₃ single crystal according to the present embodiment (beta-Ga₂O₃ single crystal manufacturing process S 100), in order to correspond to the first manufacturing method, the second manufacturing method, and the third manufacturing method which will be described later, it is preferable that Ga₂O₃ single crystal growing apparatuses 100 shown in Figs. 4 to 6 are prepared, respectively. A Ga₂O₃ single crystal growing apparatus 100 can grow a Ga₂O₃ single crystal by a vertical boat method which uses a crucible 5. Hereinafter, the vertical boat method is abbreviated as a VB method. The VB method includes a vertical Bridgeman method and a vertical temperature gradient solidification method.

### <Ga₂O₃ single crystal growing apparatus>

As is shown in Fig. 4, Ga₂O₃ single crystal growing apparatus 100 includes the above-mentioned crucible 5, a crucible holding table 6 for holding crucible 5, and a heating apparatus 7 for heating crucible 5. Ga₂O₃ single crystal growing apparatus 100 includes a stirring rod 3 which is used in Ga₂O₃ single crystal growing step S140 and is formed from a platinum-rhodium alloy. Ga₂O₃ single crystal growing apparatus 100 shown in Fig. 4 is used in the first manufacturing method which will be described later. As shown in Fig. 5, there is a case where Ga₂O₃ single crystal growing apparatus 100 includes a hollow tube 4 formed from a platinum-rhodium alloy in place of the above-mentioned stirring rod. Ga₂O₃ single crystal growing apparatus 100 shown in Fig. 5 is used in the second manufacturing method which will be described later.

Furthermore, as shown in Fig. 6, there is a case where Ga₂O₃ single crystal growing apparatus 100 has a pressure vessel 9 in which Ga₂O₃ single crystal growing apparatus 100 itself is accommodated. Ga₂O₃ single crystal growing apparatus 100 shown in Fig. 6 is used in the third manufacturing method which will be described later. The dimension, material and the like of pressure vessel 9 are not particularly limited as long as pressure vessel 9 can accommodate Ga₂O₃ single crystal growing apparatus 100 and the like and has a function of varying the internal pressure. For information, Ga₂O₃ single crystal growing apparatus 100 shown in Fig. 6 includes hollow tube 4, but this can be replaced by a stirring rod.

### (Crucible)

As shown in Figs. 4 to 6, in Ga₂O₃ single crystal growing apparatus 100, crucible 5 includes a cylindrical seed-crystal accommodating portion 51, a diameter-increasing portion 52 which is connected to seed-crystal accommodating portion 51, and a straight body portion 53 which is connected to diameter-increasing portion 52. Seed-crystal accommodating portion 51 is cylindrical and has a hollow portion that is opened on a side connected to diameter-increasing portion 52 and has a bottom wall formed on the side opposite to diameter-increasing portion 52. Seed-crystal accommodating portion 51 can accommodate and hold a seed crystal 8a in the hollow portion. Diameter-increasing portion 52 has a circular truncated cone shape of which the diameter increases upward in the axial direction of crucible 5, and is connected to seed-crystal accommodating portion 51 on a small-diameter side of diameter-increasing portion 52. Straight body portion 53 has a hollow cylindrical shape and is connected to a large-diameter side of diameter-increasing portion 52. Diameter-increasing portion 52 and straight body portion 53 have a function of holding a massive Ga₂O₃ bulk body (specifically, polycrystalline Ga₂O₃) therein. Diameter-increasing portion 52 and straight body portion 53 have a function of growing a Ga₂O₃ single crystal 81 as a crystal, by solidifying a Ga₂O₃ melt 82 as will be described later.

Crucible 5 is formed from a platinum-rhodium alloy (hereinafter, also referred to as a "Pt-Rh alloy"). It is preferable that crucible 5, in particular, is formed from a Pt-Rh alloy containing 35 mass% or more of rhodium (Rh). There is a case where crucible 5 is formed from a Pt-Rh alloy containing 35 mass% of Rh. An inside diameter of straight body portion 53 depends on a diameter of beta-Ga₂O₃ single crystal 81 to be manufactured, but is, for example, 90 mm or more and 165 mm or less.

### (Crucible holding table)

Ga₂O₃ single crystal growing apparatus 100 includes crucible holding table 6 for holding crucible 5. Crucible holding table 6 holds crucible 5 in contact with the bottom portion of crucible 5. There is a case where crucible holding table 6 has a cylindrical appearance. A material of crucible holding table 6 is not particularly limited, and for example, quartz, alumina, zirconia, silicon carbide or the like can be adopted. An outer diameter of crucible holding table 6 depends on the diameter of crucible 5 to be supported, but is, for example, 75 mm or more and 200 mm or less.

### (Heating apparatus)

Heating apparatus 7 is provided for the purpose of heating crucible 5. For example, a conventionally known electric heater (hereinafter, also simply referred to as a "heater") can be adopted as heating apparatus 7. The heater shall be, for example, two heaters, and the two heaters are arranged so as to surround an outer periphery of crucible 5. There is a case where an output of the heater is controlled independently for each unit. There is a case where the heater, in particular, is divided into a plurality of parts in a direction perpendicular to the axis of crucible 5, and thereby is configured so that the units correspond to multiple stages, respectively. In this case, it is preferable that the output of the heater is independently controlled for each of the portions which are configured in multiple stages. Thereby, it is possible to adjust a temperature of the content in crucible 5 in detail, along the axial direction of crucible 5. For example, it is possible to stabilize the growth rate of the crystal which grows in diameter-increasing portion 52 and straight body portion 53, by heating diameter-increasing portion 52 and straight body portion 53 by independently controlling the output of the heater for each of the portions configured in multiple stages.

For information, the illustration has been omitted, but Ga₂O₃ single crystal growing apparatus 100 can include a thermocouple which can measure the temperature of crucible 5 heated by the heater. There is a case where a plurality of thermocouples is arranged outside crucible 5 and along the axial direction. As the thermocouple, for example, a known temperature monitor can be adopted.

### (Stirring rod)

Ga₂O₃ single crystal growing apparatus 100 shown in Fig. 4 includes stirring rod 3. There is a case where a shape of stirring rod 3 is a rod shape having a circular cross section or a rectangular cross section. Stirring rod 3 is formed from a Pt-Rh alloy. It is preferable that stirring rod 3 is formed particularly from a Pt-Rh alloy containing 35 mass% or more of Rh. There is a case where stirring rod 3 is formed from a Pt-Rh alloy containing 35 mass% of Rh. A dimension of stirring rod 3 depends on the dimension of crucible 5, but has, for example, a length of 300 mm or more and 1000 mm or less, and a width of 3 mm or more and 10 mm or less. Stirring rod 3 is used for stirring Ga₂O₃ melt 82 in crucible 5, in Ga₂O₃ single crystal growing step S140.

### (Hollow tube)

Ga₂O₃ single crystal growing apparatus 100 shown in Fig. 5 includes hollow tube 4. There is a case where a shape of hollow tube 4 is a cylindrical shape having a hollow portion in the longitudinal direction, in other words, a cylindrical shape having an annular shape of cross section. Hollow tube 4 is formed from a Pt-Rh alloy. It is preferable that hollow tube 4 is formed particularly from a Pt-Rh alloy containing 35 mass% or more of Rh. There is a case where hollow tube 4 is formed from a Pt-Rh alloy containing 35 mass% of Rh. A dimension of hollow tube 4 depends on the dimension of crucible 5, but, for example, has a length of 300 mm or more and 1000 mm or less and an inside diameter of 1 mm or more and 10 mm or less. Hollow tube 4 is used for blowing an inert gas such as nitrogen gas or argon gas into Ga₂O₃ melt 82 in crucible 5, in Ga₂O₃ single crystal growing step S140.

Firstly, the first manufacturing method will be illustrated and described below which is one aspect of a method for manufacturing the Ga₂O₃ single crystal according to the present embodiment, with reference to the flowchart of Fig. 3 and Ga₂O₃ single crystal growing apparatus 100 shown in Fig. 4. As described above, there is a case where the method for manufacturing the beta-Ga₂O₃ single crystal according to the present embodiment is included in the method for manufacturing the beta-Ga₂O₃ single crystal substrate, which is shown as beta-Ga₂O₃ single crystal manufacturing process S100, in a flowchart in Fig. 3.

### <beta-Ga₂O₃ single crystal manufacturing process S100>

### (First manufacturing method)

### 1) First step: preparing step S110

As is shown in Fig. 3, in beta-Ga₂O₃ single crystal manufacturing process S100, firstly, a step of preparing the Ga₂O₃ single crystal growing apparatus is carried out that includes at least the cylindrical crucible and the heating apparatus that is arranged so as to surround the outer periphery of the crucible (preparing step S110). In preparing step S110, it is preferable to prepare also each of seed crystal 8a, the massive Ga₂O₃ bulk body and the solid B₂O₃ are prepared, in addition to the above-mentioned Ga₂O₃ single crystal growing apparatus 100 for manufacturing beta-Ga₂O₃ single crystal 81. Seed crystal 8a is formed of a beta-Ga₂O₃ single crystal. There is a case where the Ga₂O₃ bulk body is formed of polycrystalline Ga₂O₃. Seed crystal 8a, the massive Ga₂O₃ bulk body and the solid B₂O₃ may be prepared by a conventionally known method, or may be prepared by obtaining commercially available products.

### 2) Second step: raw material charging step S120

Raw material charging step S120 is a step of accommodating the seed crystal in the bottom portion of the crucible and accommodating the massive Ga₂O₃ bulk body in an upper portion above the seed crystal in the crucible. In raw material charging step S120, it is preferable to accommodate also the solid B₂O₃, together with the massive Ga₂O₃ bulk body in an upper portion above seed crystal 8a in crucible 5. The purpose of raw material charging step S120 is to seal various raw materials for growing a crystal into the crucible, with the use of Ga₂O₃ single crystal growing apparatus 100. In raw material charging step S120, firstly, seed crystal 8a formed of a beta-Ga₂O₃ single crystal is charged into the hollow portion of seed-crystal accommodating portion 51 of crucible 5. Next, a plurality of massive Ga₂O₃ bulk bodies formed of polycrystalline Ga₂O₃ are charged into diameter-increasing portion 52 and straight body portion 53 of crucible 5, and are stacked. Subsequently, the solid B₂O₃ is then arranged on the Ga₂O₃ bulk body. In raw material charging step S120, it is preferable to add a predetermined amount of Sn or Si, at the time when a plurality of the massive Ga₂O₃ bulk bodies is charged into crucible 5. Thereby, the beta-Ga₂O₃ single crystal substrate containing the Sn or Si as the dopant is obtained from beta-Ga₂O₃ single crystal 81 which is obtained in beta-Ga₂O₃ single crystal manufacturing process S100. At the time of the addition of the Sn or Si, it is preferable to adjust the addition amount so that the concentration of the dopant in the Ga₂O₃ single crystal substrate becomes 5.0×10¹⁹ cm⁻³ or less (for example, 5.0×10¹⁷ cm⁻³ or more and 4.0×10¹⁹ cm⁻³ or less).

### 3) Third Step: raw material melting step S130

Raw material melting step S130 is a step of heating the crucible with the heating apparatus to melt the Ga₂O₃ bulk body and a part of the seed crystal, thereby obtaining a Ga₂O₃ melt, and also contacting the Ga₂O₃ melt with the remaining portion of the seed crystal. The purpose of raw material melting step S130 is to melt a part of the Ga₂O₃ bulk body and seed crystal 8a, thereby contacting the remaining portion of seed crystal 8a with Ga₂O₃ melt 82, at the time of growing a crystal with the use of Ga₂O₃ single crystal growing apparatus 100. Thereby, in Ga₂O₃ single crystal growing step S140 which is the next step, it becomes possible to grow beta-Ga₂O₃ single crystal 81 on the remaining portion of seed crystal 8a. In raw material melting step S130, specifically, crucible 5 containing seed crystal 8a, the Ga₂O₃ bulk body and the solid B₂O₃ accommodated inside is supported by crucible holding table 6. After that, an electric current is supplied to heating apparatus 7, and crucible 5 is heated. Thereby, the solid B₂O₃ is melted to become liquid B₂O₃ which functions as a liquid sealing material, and the Ga₂O₃ bulk body is melted to become Ga₂O₃ melt 82. Subsequently, a part of seed crystal 8a is also melted, and the remaining portion of seed crystal 8a and Ga₂O₃ melt 82 are contacted with each other at the interface.

### 4) Fourth step: Ga₂O₃ single crystal growing step S140

Ga₂O₃ single crystal growing step S140 is a step of obtaining the Ga₂O₃ single crystal, by growing a crystal from the Ga₂O₃ melt on the remaining portion of the seed crystal. In Ga₂O₃ single crystal growing step S140, it is possible to form such a temperature gradient in crucible 5 that the temperature on seed crystal 8a side is low and the temperature on Ga₂O₃ melt 82 side is high, for example, by gradually lowering crucible 5 downward (toward seed-crystal accommodating portion 51 side) along the axis with respect to heating apparatus 7. Thereby, it becomes possible to solidify Ga₂O₃ melt 82 in contact with seed crystal 8a, and continuously grow beta-Ga₂O₃ single crystal 81 from Ga₂O₃ melt 82 on the remaining portion of seed crystal 8a. At this time, the temperature on Ga₂O₃ melt 82 side is, for example, 1800 to 1820°C. The temperature gradient at the interface between Ga₂O₃ melt 82 and the growing beta-Ga₂O₃ single crystal 81 is, for example, 3 to 8°C/cm. The speed at which crucible 5 is pulled downward along the axis is not particularly limited, and can be set to, for example, 0.1 to 2 mm/hour.

In addition, Ga₂O₃ single crystal growing step S140 includes a step of inserting a stirring rod formed from a platinum-rhodium alloy into the Ga₂O₃ melt, and growing the crystal while stirring the Ga₂O₃ melt with the stirring rod (hereinafter, also referred to as a "stirring step"). In the stirring step, firstly, stirring rod 3 formed from a Pt-Rh alloy is accommodated in crucible 5 in such a way that the tip of stirring rod 3 is inserted into Ga₂O₃ melt 82 in crucible 5. Specifically, the tip of stirring rod 3 is accommodated in crucible 5 in such a way as to be inserted into Ga₂O₃ melt 82 at a position about 10 to 20 mm above the interface between Ga₂O₃ melt 82 and the growing beta-Ga₂O₃ single crystal 81 in crucible 5, and near the center in a radial direction of crucible 5. Next, Ga₂O₃ melt 82 is stirred by the tip of stirring rod 3 which is rotated so as to draw an arc at the above-mentioned position in Ga₂O₃ melt 82. Thereby, bubbles 2 formed from excess oxygen (O₂) which does not constitute the Ga₂O₃ are discharged, at the above-mentioned position in Ga₂O₃ melt 82 and the periphery thereof, to the outside of crucible 5 or at least to the outside of Ga₂O₃ melt 82. As a result, the stirring of Ga₂O₃ melt 82 by stirring rod 3 can suppress the formation of the line-shaped hole which originates in a bubble 2 in beta-Ga₂O₃ single crystal 81. The formation of the line-shaped hole is further suppressed particularly in the central portion of beta-Ga₂O₃ single crystal 81, in other words, in the portion of beta-Ga₂O₃ single crystal 81, which corresponds to the above-mentioned position in Ga₂O₃ melt 82 and the periphery thereof.

In Ga₂O₃ single crystal growing step S140, crucible 5 is pulled downward along the axis thereof with respect to heating apparatus 7, thereby the interface between beta-Ga₂O₃ single crystal 81 and Ga₂O₃ melt 82 is raised toward a liquid B₂O₃ side, and Ga₂O₃ melt 82 is solidified as beta-Ga₂O₃ single crystal 81. Thereby, the growth of beta-Ga₂O₃ single crystal 81 is continued until Ga₂O₃ melt 82 remaining in straight body portion 53 of crucible 5 is completely solidified. In the way, an ingot of beta-Ga₂O₃ single crystal 81 can be obtained in which the formation of the line-shaped hole in the central portion is suppressed.

### (Second manufacturing method)

The second manufacturing method can be performed in the same manner as the first manufacturing method, in the steps other than Ga₂O₃ single crystal growing step S140. Thereby, also in the second manufacturing method, an ingot of beta-Ga₂O₃ single crystal 81 can be obtained in which the formation of the line-shaped hole is suppressed in the central portion. The Ga₂O₃ single crystal growing step S140 in the second manufacturing method is different from the first manufacturing method, in the following feature.

Specifically, the Ga₂O₃ single crystal growing step S140 in the second manufacturing method can include a step of inserting a hollow tube formed from a platinum-rhodium alloy into the Ga₂O₃ melt, in place of the stirring step in the first manufacturing method, and a step of growing the crystal while blowing an inert gas into the Ga₂O₃ melt through the hollow tube (hereinafter, also referred to as a "gas blowing step"). As shown in Fig. 5, in the gas blowing step, firstly, the tip of hollow tube 4 formed from a Pt-Rh alloy is accommodated in crucible 5 in such a way as to be inserted into Ga₂O₃ melt 82 at a position about 10 to 20 mm above the interface between Ga₂O₃ melt 82 and growing beta-Ga₂O₃ single crystal 81 in crucible 5, and near the center in a radial direction of crucible 5. Next, an inert gas is blown into Ga₂O₃ melt 82 from the outside with the use of hollow tube 4. Here, examples of the inert gas include nitrogen gas and argon gas, and it is particularly preferable that the inert gas is argon gas having a high purity of 99.9999 mass%. Thereby, it becomes possible to discharge bubbles 2 formed of excess O₂ which does not constitute the Ga₂O₃, to the outside of crucible 5 or at least to the outside of Ga₂O₃ melt 82, together with the inert gas, at the above-mentioned position in Ga₂O₃ melt 82 and the periphery thereof. As a result, the blowing of the inert gas into Ga₂O₃ melt 82 through hollow tube 4 can suppress the formation of the line-shaped hole which originates in bubble 2 in beta-Ga₂O₃ single crystal 81. The formation of the line-shaped hole is further suppressed particularly in the central portion of beta-Ga₂O₃ single crystal 81, in other words, in the portion of beta-Ga₂O₃ single crystal 81, which corresponds to the above-mentioned position in Ga₂O₃ melt 82 and the periphery thereof.

In addition, it is also preferable that Ga₂O₃ single crystal growing step S140 in the second manufacturing method includes a step of stirring the Ga₂O₃ melt with the hollow tube. Specifically, firstly, the tip of hollow tube 4 formed from a Pt-Rh alloy is inserted into the above-mentioned position in Ga₂O₃ melt 82 in crucible 5, and then Ga₂O₃ melt 82 is stirred with hollow tube 4. In other words, in Ga₂O₃ single crystal growing step S140 in the second manufacturing method, the stirring step in the first manufacturing method can also be performed together with the gas blowing step which uses hollow tube 4. Thereby, it becomes possible to more effectively discharge bubbles 2 in Ga₂O₃ melt 82 to the outside of crucible 5 or at least to the outside of Ga₂O₃ melt 82.

### (Third manufacturing method)

The third manufacturing method incorporates the following features into the above-mentioned single crystal growing apparatus and the like, and performs the above-mentioned first manufacturing method or second manufacturing method. Specifically, in the third manufacturing method, the single crystal growing apparatus is accommodated in the pressure vessel. Furthermore, the manufacturing method includes a step of repeating an operation of reducing the pressure in the pressure vessel from 1 atm and then returning the pressure to the 1 atm, three or more times, after the step of contacting the Ga₂O₃ melt with the remaining portion of the seed crystal and before the step of obtaining the beta-Ga₂O₃ single crystal. In the third manufacturing method, specifically as shown in Fig. 6, Ga₂O₃ single crystal growing apparatus 100 is accommodated in pressure vessel 9, and then, the above-mentioned first manufacturing method or the second manufacturing method is performed. In particular, after raw material melting step S130 and before Ga₂O₃ single crystal growing step S140, such an operation is repeated three times or more as to reduce the inner pressure of pressure vessel 9 from 1 atm to, for example, 0.1 to 0.8 atm and then return the inner pressure to the 1 atm (hereinafter, also referred to as "pressure-varying operation"). In other words, in the third manufacturing method, the above-mentioned pressure-varying operation is performed before crucible 5 is gradually pulled downward along the axis with respect to heating apparatus 7, in Ga₂O₃ single crystal growing step S140. Thereby, it becomes possible to positively discharge bubbles 2 existing at and around the above-mentioned position in Ga₂O₃ melt 82 to the outside of crucible 5 or at least to the outside of Ga₂O₃ melt 82, by a pressure variation of an atmosphere, in addition to the action of the above-mentioned first manufacturing method or the second manufacturing method. As described above, in the third manufacturing method, an ingot of beta-Ga₂O₃ single crystal 81 in which the formation of the line-shaped hole in the central portion is further suppressed can be obtained, as compared with the above-mentioned first manufacturing method and the second manufacturing method.

### [Method for manufacturing beta-digallium trioxide single crystal substrate]

### <Beta-Ga₂O₃ single crystal substrate manufacturing process S200>

A method for manufacturing a beta-Ga₂O₃ single crystal substrate according to the present embodiment includes a step of processing the beta-Ga₂O₃ single crystal obtained by the method for manufacturing the beta-Ga₂O₃ single crystal, and obtaining the beta-Ga₂O₃ single crystal substrate having a circular main surface. As shown in Fig. 3, the method for manufacturing the beta-Ga₂O₃ single crystal substrate includes beta-Ga₂O₃ single crystal manufacturing process S100, and beta-Ga₂O₃ single crystal substrate manufacturing process S200. The purpose of beta-Ga₂O₃ single crystal substrate manufacturing process S200 is to obtain the beta-Ga₂O₃ single crystal substrate by processing the beta-Ga₂O₃ single crystal obtained in beta-Ga₂O₃ single crystal manufacturing process S100. Beta-Ga₂O₃ single crystal substrate manufacturing process S200 includes the following cutting step, outer periphery grinding step and polishing step, and the beta-Ga₂O₃ single crystal substrate can be obtained by performing these steps in this order.

The cutting step is a step of slicing the ingot formed of the beta-Ga₂O₃ single crystal which has been taken out from the crucible so that the ingot becomes wafers each having a predetermined thickness, in order to obtain beta-Ga₂O₃ single crystal substrates from the ingot. Furthermore, the outer periphery grinding step is a step of grinding the outer periphery of the wafer, and thereby obtaining the beta-Ga₂O₃ single crystal substrate having the circular main surface. The outer periphery grinding step can include, for example, a step of performing a chamfering process. As the cutting step and the outer periphery grinding step, a conventionally known cutting method and an outer periphery grinding method can be used. Furthermore, the polishing step is a step of mirror-polishing the central portion of the main surface. As the polishing step, a conventionally known polishing method can be used. The polishing step can adjust a surface roughness Ra of the central portion to 10 nm or less, which is defined in JIS B 0681-2: 2018, for example.

### [Action and Effect]

Due to each of the above steps being carried out, the beta-Ga₂O₃ single crystal substrate according to the present embodiment is manufactured. In the method for manufacturing the beta-Ga₂O₃ single crystal, the ingot of the beta-Ga₂O₃ single crystal in which the formation of the line-shaped hole in the central portion is suppressed can be obtained, particularly in Ga₂O₃ single crystal growing step S140. Thereby, from the ingot of the beta-Ga₂O₃ single crystal, the beta-Ga₂O₃ single crystal substrate can be obtained in which the density of line-shaped holes is larger at the outer periphery of the main surface than at the central portion. As a result, the cracking defect rate can be reduced in the beta-Ga₂O₃ single crystal substrate.

### [Examples]

The present disclosure will be described below in more detail with reference to Examples, but the present disclosure is not limited thereto. In the present Example, a Ga₂O₃ single crystal substrate was manufactured according to a flowchart shown in Fig. 3, with the use of a Ga₂O₃ single crystal manufacturing apparatus as shown in Fig. 4 to Fig. 6. In the following description, a sample 11 to a sample 15, a sample 21 to a sample 25 and a sample 31 to a sample 33 are Examples, and a sample 101 to a sample 105 are Comparative Examples.

### [Manufacturing of beta-Ga₂O₃ single crystal substrate]

### <Sample 11>

### (Beta-Ga₂O₃ single crystal manufacturing process S100)

### 1) Preparing step S110

Firstly, a Ga₂O₃ single crystal growing apparatus 100, a seed crystal 8a formed of a Ga₂O₃ single crystal, a massive Ga₂O₃ bulk body formed of a polycrystalline Ga₂O₃ and solid B₂O₃ were prepared by a conventionally known method or by obtaining commercially available products. A crucible 5 constituting Ga₂O₃ single crystal growing apparatus 100 is formed from a Pt-Rh alloy containing 35 mass% of Rh. An inside diameter of a straight body portion 53 of crucible 5 is 110 mm.

### 2) Raw material charging step S120

Next, by a conventionally known method, seed crystal 8a was accommodated in a bottom portion of crucible 5, and the Ga₂O₃ bulk body and solid B₂O₃ were accommodated in an upper portion above seed crystal 8a in crucible 5. Specifically, seed crystal 8a formed of the Ga₂O₃ single crystal was charged into a hollow portion of a seed-crystal accommodating portion 51 of crucible 5. A plurality of massive Ga₂O₃ bulk bodies were charged into a diameter-increasing portion 52 and straight body portion 53 of crucible 5, and were stacked. Subsequently, the solid B₂O₃ was arranged on the Ga₂O₃ bulk body. Furthermore, when a plurality of massive Ga₂O₃ bulk bodies were charged into crucible 5, a predetermined amount of Sn was added. The amount of Sn to be added was set to an amount at which the atomic concentration of Sn in the beta-Ga₂O₃ single crystal substrate became 1×10¹⁸ cm⁻³.

### 3) Raw material melting step S130

Next, crucible 5 which contained seed crystal 8a, the Ga₂O₃ bulk body, and the solid B₂O₃ accommodated inside was supported by a crucible holding table 6 formed from zirconia. After that, an electric current was supplied to a heating apparatus 7 to have heated crucible 5, thereby to have melted and converted the solid B₂O₃ into a liquid B₂O₃, and also to have melted and converted the Ga₂O₃ bulk body into a Ga₂O₃ melt 82. Subsequently, a part of seed crystal 8a was also melted, and a remaining portion of seed crystal 8a was contacted with Ga₂O₃ melt 82, at the interface.

### 4) Ga₂O₃ single crystal growing step S140

Next, crucible 5 was gradually pulled downward (toward seed-crystal accommodating portion 51 side) along the axis with respect to heating apparatus 7, and thereby such a temperature gradient was formed that a temperature on seed crystal 8a side in crucible 5 was low and a temperature on Ga₂O₃ melt 82 side was high. Thereby, Ga₂O₃ melt 82 in contact with seed crystal 8a was solidified, and a beta-Ga₂O₃ single crystal 81 was continuously grown from Ga₂O₃ melt 82 on the remaining portion of seed crystal 8a. Furthermore, this operation was continued until Ga₂O₃ melt 82 remaining in straight body portion 53 of crucible 5 was completely solidified. At this time, a temperature on Ga₂O₃ melt 82 side was set to 1800 to 1820°C. The temperature gradient at the interface between Ga₂O₃ melt 82 and growing beta-Ga₂O₃ single crystal 81 was set to 5°C/cm. A speed at which crucible 5 was pulled downward along the axis was set to 0.8 mm/hour.

In addition, in a Ga₂O₃ single crystal growing step S140, the following stirring step was performed. Specifically, a stirring rod 3 was accommodated in crucible 5 so that the tip of stirring rod 3 formed from a Pt-Rh alloy was inserted into Ga₂O₃ melt 82 at a position of an upper portion 10 mm above the interface between Ga₂O₃ melt 82 and growing beta-Ga₂O₃ single crystal 81 in crucible 5, and near the center in a radial direction of crucible 5. Furthermore, the tip of stirring rod 3 was rotated so as to draw an arc at the above-mentioned position in Ga₂O₃ melt 82. Thereby, Ga₂O₃ melt 82 was stirred, and bubbles 2 formed of excess O₂ which did not constitute Ga₂O₃ were discharged to the outside of crucible 5 or at least to the outside of Ga₂O₃ melt 82, at the above-mentioned position in Ga₂O₃ melt 82 and the periphery thereof.

### (Ga₂O₃ single crystal substrate manufacturing process S200)

Finally, an ingot of beta-Ga₂O₃ single crystal 81 obtained in Ga₂O₃ single crystal growing step S140 was processed in the respective steps of cutting, outer periphery grinding and polishing, and thereby, beta-Ga₂O₃ single crystal substrates were obtained. Firstly, in the cutting step, the ingot was sliced into wafers each having a thickness of 700 µm with the use of a conventionally known method. The number of thereby obtained wafers was 25 sheets. The 25 sheets correspond to "the number of substrates per crystal" in Table 1 and Table 2 shown below. Next, in the outer periphery grinding step, the outer periphery of the wafer was subjected to the chamfering process with the use of a conventionally known method, and thereby, a beta-Ga₂O₃ single crystal substrate having a circular main surface was obtained. The main surface of the beta-Ga₂O₃ single crystal substrate is formed of a first region of a circular shape which has a diameter of a length of 0.75D and is centered at the center and a second region which is a region outside of the first region. Furthermore, in the polishing step, at least the first region was polished with the use of a conventionally known polishing method, and thereby, a surface roughness Ra in the first region was adjusted to 8 nm, which is defined in JIS B 0681-2: 2018. In the way, a Ga₂O₃ single crystal substrate of sample 11 was manufactured. In addition, a time period from the end of a raw material melting step S130 to the start of Ga₂O₃ single crystal growing step S140 was set to 24 hours.

The main surface of the Ga₂O₃ single crystal substrate of sample 11 was a face having an off-angle of 0.2° from the (001) plane of the Ga₂O₃ single crystal and an off-direction in the [010] direction of the Ga₂O₃ single crystal, according to the above-mentioned crystal orientation measuring apparatus.

### <Sample 12>

A beta-Ga₂O₃ single crystal substrate of a sample 12 was manufactured in the same manner as in the method for manufacturing the beta-Ga₂O₃ single crystal substrate of sample 11, except that 10 sheets of wafers each having a thickness of 700 µm were obtained by the cutting step in beta-Ga₂O₃ single crystal substrate manufacturing process S200.

The main surface of the Ga₂O₃ single crystal substrate of sample 12 was a face having an off-angle of 0.2° from the (001) plane of the Ga₂O₃ single crystal and an off-direction in the [010] direction of the Ga₂O₃ single crystal, according to the above-mentioned crystal orientation measuring apparatus.

### <Sample 13>

A beta-Ga₂O₃ single crystal substrate of a sample 13 was manufactured in the same manner as in the method for manufacturing the beta-Ga₂O₃ single crystal substrate of sample 11, except that 13 sheets of wafers each having a thickness of 700 µm were obtained by the cutting step in beta-Ga₂O₃ single crystal substrate manufacturing process S200.

The main surface of the Ga₂O₃ single crystal substrate of sample 13 was a face having an off-angle of 0.2° from the (001) plane of the Ga₂O₃ single crystal and an off-direction in the [010] direction of the Ga₂O₃ single crystal, according to the above-mentioned crystal orientation measuring apparatus.

### <Sample 14>

A beta-Ga₂O₃ single crystal substrate of a sample 14 was manufactured in the same manner as in the method for manufacturing the beta-Ga₂O₃ single crystal substrate of sample 11, except that crucible 5 having straight body portion 53 with the inside diameter of 160 mm was prepared in preparing step S110, and that 16 sheets of wafers each having a thickness of 700 µm were obtained by the cutting step in beta-Ga₂O₃ single crystal substrate manufacturing process S200. In addition, the time period from the end of raw material melting step S130 to the start of Ga₂O₃ single crystal growing step S140 was set to 36 hours.

The main surface of the Ga₂O₃ single crystal substrate of sample 14 was a face having an off-angle of 0.2° from the (001) plane of the Ga₂O₃ single crystal and an off-direction in the [010] direction of the Ga₂O₃ single crystal, according to the above-mentioned crystal orientation measuring apparatus.

### <Sample 15>

A beta-Ga₂O₃ single crystal substrate of a sample 15 was manufactured in the same manner as in the method for manufacturing the beta-Ga₂O₃ single crystal substrate of sample 14, except that 10 sheets of wafers each having a thickness of 700 µm were obtained by the cutting step in beta-Ga₂O₃ single crystal substrate manufacturing process S200.

The main surface of the Ga₂O₃ single crystal substrate of sample 15 was a face having an off-angle of 0.2° from the (001) plane of the Ga₂O₃ single crystal and an off-direction in the [010] direction of the Ga₂O₃ single crystal, according to the above-mentioned crystal orientation measuring apparatus.

### <Sample 21>

A beta-Ga₂O₃ single crystal substrate of a sample 21 was manufactured in the same manner as in the method for manufacturing the beta-Ga₂O₃ single crystal substrate of sample 11, except that the following gas blowing step was performed in place of the above-mentioned stirring step in Ga₂O₃ single crystal growing step S140, and that 12 sheets of wafers each having a thickness of 700 µm were obtained by the cutting step in beta-Ga₂O₃ single crystal substrate manufacturing process S200.

Specifically, in the gas blowing step, firstly, a hollow tube 4 was accommodated in crucible 5 in such a way that the tip of hollow tube 4 formed from a Pt-Rh alloy is inserted into a position about 3 mm above the interface between Ga₂O₃ melt 82 and growing beta-Ga₂O₃ single crystal 81 in crucible 5, and near the center in a radial direction of crucible 5, in Ga₂O₃ melt 82. Subsequently, 99.9999 mass% of high-purity argon gas was blown into Ga₂O₃ melt 82 from the outside with the use of hollow tube 4. Thereby, bubbles 2 formed of excess O₂ which did not constitute the Ga₂O₃ was discharged to the outside of crucible 5 or at least to the outside of Ga₂O₃ melt 82, together with the above high-purity argon gas, at the above-mentioned position in Ga₂O₃ melt 82 and the periphery thereof.

The main surface of the Ga₂O₃ single crystal substrate of sample 21 was a face having an off-angle of 0.2° from the (001) plane of the Ga₂O₃ single crystal and an off-direction in the [010] direction of the Ga₂O₃ single crystal, according to the above-mentioned crystal orientation measuring apparatus.

### <Sample 22>

A beta-Ga₂O₃ single crystal substrate of a sample 22 was manufactured in the same manner as in the method for manufacturing the beta-Ga₂O₃ single crystal substrate of sample 21, except that 22 sheets of wafers each having a thickness of 700 µm were obtained by the cutting step in beta-Ga₂O₃ single crystal substrate manufacturing process S200.

The main surface of the Ga₂O₃ single crystal substrate of sample 22 was a face having an off-angle of 0.2° from the (001) plane of the Ga₂O₃ single crystal and an off-direction in the [010] direction of the Ga₂O₃ single crystal, according to the above-mentioned crystal orientation measuring apparatus.

### <Sample 23>

A beta-Ga₂O₃ single crystal substrate of a sample 23 was manufactured in the same manner as in the method for manufacturing the beta-Ga₂O₃ single crystal substrate of sample 21, except that 10 sheets of wafers each having a thickness of 700 µm were obtained by the cutting step in beta-Ga₂O₃ single crystal substrate manufacturing process S200.

The main surface of the Ga₂O₃ single crystal substrate of sample 23 was a face having an off-angle of 0.2° from the (001) plane of the Ga₂O₃ single crystal and an off-direction in the [010] direction of the Ga₂O₃ single crystal, according to the above-mentioned crystal orientation measuring apparatus.

### <Sample 24>

A beta-Ga₂O₃ single crystal substrate of a sample 24 was manufactured in the same manner as in the method for manufacturing the beta-Ga₂O₃ single crystal substrate of sample 21, except that crucible 5 having straight body portion 53 with the inside diameter of 160 mm was prepared in preparing step S110, and that 10 sheets of wafers each having a thickness of 700 µm were obtained by the cutting step in beta-Ga₂O₃ single crystal substrate manufacturing process S200. In addition, the time period from the end of raw material melting step S130 to the start of Ga₂O₃ single crystal growing step S140 was set to 36 hours.

The main surface of the Ga₂O₃ single crystal substrate of sample 24 was a face having an off-angle of 0.2° from the (001) plane of the Ga₂O₃ single crystal and an off-direction in the [010] direction of the Ga₂O₃ single crystal, according to the above-mentioned crystal orientation measuring apparatus.

### <Sample 25>

A beta-Ga₂O₃ single crystal substrate of a sample 25 was manufactured in the same manner as in the method for manufacturing the beta-Ga₂O₃ single crystal substrate of sample 24, except that 8 sheets of wafers each having a thickness of 700 µm were obtained by the cutting step in beta-Ga₂O₃ single crystal substrate manufacturing process S200.

The main surface of the Ga₂O₃ single crystal substrate of sample 25 was a face having an off-angle of 0.2° from the (001) plane of the Ga₂O₃ single crystal and an off-direction in the [010] direction of the Ga₂O₃ single crystal, according to the above-mentioned crystal orientation measuring apparatus.

### <Sample 31>

A beta-Ga₂O₃ single crystal substrate of a sample 31 was manufactured in the same manner as in the method for manufacturing the beta-Ga₂O₃ single crystal substrate of sample 21, except that in raw material melting step S130, Ga₂O₃ single crystal growing apparatus 100 was accommodated in pressure vessel 9, then, crucible 5 was heated by heating apparatus 7, and thereby, seed crystal 8a was contacted with Ga₂O₃ melt 82, that the pressure-varying operation was repeated three times, which included reducing the pressure in pressure vessel 9 from 1 atm to 0.5 atm and then returning to the 1 atm, after raw material melting step S130 and before Ga₂O₃ single crystal growing step S140, and that 10 sheets of wafers each having a thickness of 700 µm were obtained by the cutting step in beta-Ga₂O₃ single crystal substrate manufacturing process S200. In addition, the time period from the end of raw material melting step S130 to the start of Ga₂O₃ single crystal growing step S140 was set to 20 hours.

The main surface of the Ga₂O₃ single crystal substrate of sample 31 was a face having an off-angle of 0.2° from the (001) plane of the Ga₂O₃ single crystal and an off-direction in the [010] direction of the Ga₂O₃ single crystal, according to the above-mentioned crystal orientation measuring apparatus.

### <Sample 32>

A beta-Ga₂O₃ single crystal substrate of a sample 32 was manufactured in the same manner as in the method for manufacturing the beta-Ga₂O₃ single crystal substrate of sample 31, except that 8 sheets of wafers each having a thickness of 700 µm were obtained by the cutting step in beta-Ga₂O₃ single crystal substrate manufacturing process S200.

The main surface of the Ga₂O₃ single crystal substrate of sample 32 was a face having an off-angle of 0.2° from the (001) plane of the Ga₂O₃ single crystal and an off-direction in the [010] direction of the Ga₂O₃ single crystal, according to the above-mentioned crystal orientation measuring apparatus.

### <Sample 33>

A beta-Ga₂O₃ single crystal substrate of a sample 33 was manufactured in the same manner as in the method for manufacturing the beta-Ga₂O₃ single crystal substrate of sample 31, except that crucible 5 having straight body portion 53 with the inside diameter of 160 mm was prepared in preparing step S110, and that 5 sheets of wafers each having a thickness of 700 µm were obtained by the cutting step in beta-Ga₂O₃ single crystal substrate manufacturing process S200. In addition, the time period from the end of raw material melting step S130 to the start of Ga₂O₃ single crystal growing step S140 was set to 32 hours.

The main surface of the Ga₂O₃ single crystal substrate of sample 33 was a face having an off-angle of 0.2° from the (001) plane of the Ga₂O₃ single crystal and an off-direction in the [010] direction of the Ga₂O₃ single crystal, according to the above-mentioned crystal orientation measuring apparatus.

### <Sample 101>

A beta-Ga₂O₃ single crystal substrate of a sample 101 was manufactured in the same manner as in the method for manufacturing the beta-Ga₂O₃ single crystal substrate of sample 11, except that the stirring step was not performed in Ga₂O₃ single crystal growing step S140, and that 20 sheets of wafers each having a thickness of 700 µm were obtained by the cutting step in beta-Ga₂O₃ single crystal substrate manufacturing process S200.

The main surface of the Ga₂O₃ single crystal substrate of sample 101 was a face having an off-angle of 0.2° from the (001) plane of the Ga₂O₃ single crystal and an off-direction in the [010] direction of the Ga₂O₃ single crystal, according to the above-mentioned crystal orientation measuring apparatus.

### <Sample 102>

A beta-Ga₂O₃ single crystal substrate of a sample 102 was manufactured in the same manner as in the method for manufacturing the beta-Ga₂O₃ single crystal substrate of sample 101, except that 33 sheets of wafers each having a thickness of 700 µm were obtained by the cutting step in beta-Ga₂O₃ single crystal substrate manufacturing process S200.

The main surface of the Ga₂O₃ single crystal substrate of sample 102 was a face having an off-angle of 0.2° from the (001) plane of the Ga₂O₃ single crystal and an off-direction in the [010] direction of the Ga₂O₃ single crystal, according to the above-mentioned crystal orientation measuring apparatus.

### <Sample 103>

A beta-Ga₂O₃ single crystal substrate of a sample 103 was manufactured in the same manner as in the method for manufacturing the beta-Ga₂O₃ single crystal substrate of sample 101, except that 5 sheets of wafers each having a thickness of 700 µm were obtained by the cutting step in beta-Ga₂O₃ single crystal substrate manufacturing process S200.

The main surface of the Ga₂O₃ single crystal substrate of sample 103 was a face having an off-angle of 0.2° from the (001) plane of the Ga₂O₃ single crystal and an off-direction in the [010] direction of the Ga₂O₃ single crystal, according to the above-mentioned crystal orientation measuring apparatus.

### <Sample 104>

A beta-Ga₂O₃ single crystal substrate of a sample 104 was manufactured in the same manner as in the method for manufacturing the beta-Ga₂O₃ single crystal substrate of sample 101, except that crucible 5 having straight body portion 53 with the inside diameter of 160 mm was prepared in preparing step S110, and that 10 sheets of wafers each having a thickness of 700 µm were obtained by the cutting step in beta-Ga₂O₃ single crystal substrate manufacturing process S200. In addition, the time period from the end of raw material melting step S130 to the start of Ga₂O₃ single crystal growing step S140 was set to 36 hours.

The main surface of the Ga₂O₃ single crystal substrate of sample 104 was a face having an off-angle of 0.2° from the (001) plane of the Ga₂O₃ single crystal and an off-direction in the [010] direction of the Ga₂O₃ single crystal, according to the above-mentioned crystal orientation measuring apparatus.

### <Sample 105>

A beta-Ga₂O₃ single crystal substrate of a sample 105 was manufactured in the same manner as in the method for manufacturing the beta-Ga₂O₃ single crystal substrate of sample 104, except that 20 sheets of wafers each having a thickness of 700 µm were obtained by the cutting step in beta-Ga₂O₃ single crystal substrate manufacturing process S200.

The main surface of the Ga₂O₃ single crystal substrate of sample 105 was a face having an off-angle of 0.2° from the (001) plane of the Ga₂O₃ single crystal and an off-direction in the [010] direction of the Ga₂O₃ single crystal, according to the above-mentioned crystal orientation measuring apparatus.

### [Evaluation]

### <Measurement of first density and second density, and calculation of second density/first density>

The first densities and the second densities of beta-Ga₂O₃ single crystal substrates of samples 11 to 15, samples 21 to 25, samples 31 to 33 and samples 101 to 105 were determined by the above-mentioned measuring method, and the second densities / first densities were calculated. The results are shown in Table 1 and Table 2. The numerical values of the first density and the second density, and the second density/first density shown in Table 1 and Table 2 are average values of the number of substrates per predetermined one crystal in each sample. Shown in Table 1 and Table 2.

### <Measurement of cracking defect rate>

An Epitaxial film formed of a Ga₂O₃ film was formed on the main surfaces of the beta-Ga₂O₃ single crystal substrates of samples 11 to 15, samples 21 to 25, samples 31 to 33 and samples 101 to 105, by an HVPE (Hydride Vapor Phase Epitaxy) method in the following reaction furnace, under the conditions which will be described next. Next, the beta-Ga₂O₃ single crystal substrate on which the epitaxial film was formed was cooled to room temperature in the furnace, and then taken out from the furnace. The cracking defect rate was determined, by dividing the number of substrates that were cracked at this time by the number of substrates that were subjected to the HPVE method, and expressing the resultant in a form of percentage. The results are shown in Table 1 and Table 2.

### (Conditions of HVPE method for stacking Ga₂O₃ film on beta-Ga₂O₃ single crystal substrate)

Reaction furnace: hot wall type reaction furnace formed from quartz Carrier gas: nitrogen (N₂) gas
Raw material gas: oxygen (O₂) gas, and gallium chloride (GaCl) gas which was formed by spraying hydrogen chloride (HCl) gas onto metallic gallium (Ga)
Dopant: tetrachlorosilane (SiCl₄), where the doping amount is controlled so that Nd-Na becomes about 1×10¹⁶ cm⁻³.
Growth temperature: 1000°C
Growth rate: 15 µm/hour
Growth thickness: 5 µm.

### <Measurement of leakage current defect rate of Schottky barrier diode>

Schottky barrier diodes were produced from the beta-Ga₂O₃ single crystal substrates of samples 11 to 15, samples 21 to 25, samples 31 to 33 and samples 101 to 105, by a method which will be described next. A leakage current value was measured at the time when a reverse voltage of 50V was applied to the Schottky barrier diode, and when the leakage current value exceeded 1.0×10⁻⁵ ampere/cm², this diode was determined to be a defective device. In the way, the leakage current defect rate was determined, by dividing the number of defective devices generated in each sample by the number of substrates on which the Schottky barrier diode was produced from each sample, and expressing the resultant in a form of a percentage. The results are shown in Table 1 and Table 2.

### (Method for producing Schottky barrier diode)

Firstly, a chip of a 2.5 mm square was obtained from the beta-Ga₂O₃ single crystal substrate of each sample. Next, a silicon (Si) ion was implanted into the whole surface on the back surface side of the (001) plane on the chip, and the chip was further annealed at 950°C for 30 minutes. Subsequently, Ti (100 nm thick) / Ni (100 nm thick) / Au (100 nm thick) were sequentially vapor-deposited on the back surface side of the (001) plane of the chip, and thereby a whole surface electrode was formed. On surface side of the (001) plane of the chip, Ni (100 nm thick) / Au (100 nm thick) was vapor-deposited through a metal mask in which a plurality of holes each having a diameter of 600 µm are formed, and thereby Schottky electrodes each having a diameter of 600 µm were formed in a checkerboard pattern at equal intervals. In the way, a Schottky barrier diode was obtained from the beta-Ga₂O₃ single crystal substrate of each sample.

### <Calculation of device yield index>

The device yield index of each sample was calculated by multiplying the cracking defect rate obtained in the beta-Ga₂O₃ single crystal substrate of each of samples 11 to 15, samples 21 to 25, samples 31 to 33 and samples 101 to 105, by the leakage current defect rate of the Schottky barrier diode. The results are shown in Table 1 and Table 2. As described above, the smaller the value of the device yield index is, the more satisfactorily the device yield can be evaluated.

### [Table 1]

**Table. 1**

| | Diameter (mm) | Number of substrates per crystal | First density (cm⁻²) | Second density (cm⁻²) | Second density / First density | Cracking defect rate (%) | Leakage current defect rate (%) | **Device** yield index (10⁻⁴) |
|---|---|---|---|---|---|---|---|---|
| Sample 11 | 100 | 25 | 800 | 1000 | 1.3 | 12 | 46 | 552 |
| Sample 12 | 100 | 10 | 300 | 500 | 1.7 | 10 | 40 | 400 |
| Sample 13 | 100 | 13 | 200 | 500 | 2.5 | 8 | 38 | 304 |
| Sample 14 | 150 | 16 | 670 | 1000 | 1.5 | 13 | 56 | 728 |
| Sample 15 | 150 | 10 | 500 | 1000 | 2.0 | 10 | 50 | 500 |
| Sample 21 | 100 | 12 | 80 | 90 | 1.1 | 8 | 25 | 200 |
| Sample 22 | 100 | 22 | 30 | 50 | 1.7 | 9 | 23 | 207 |
| Sample 23 | 100 | 10 | 5 | 10 | 2.0 | 8 | 20 | 160 |
| Sample 24 | 150 | 10 | 85 | 90 | 1.1 | 10 | 30 | 300 |
| Sample 25 | 150 | 8 | 50 | 80 | 1.6 | 11 | 25 | 275 |
| Sample 31 | 100 | 10 | 75 | 80 | 1.1 | 10 | 22 | 220 |
| Sample 32 | 100 | 8 | 30 | 40 | 1.3 | 9 | 25 | 225 |
| Sample 33 | 150 | 5 | 70 | 80 | 1.1 | 10 | 30 | 300 |

### [Table 2]

**Table. 2**

| | Diameter (mm) | Number of substrates per crystal | First density (cm⁻²) | Second density (cm⁻²) | Second density / First density | Cracking defect rate (%) | Leakage current defect rate (%) | **Device** yield index (10⁻⁴) |
|---|---|---|---|---|---|---|---|---|
| Sample 101 | 100 | 20 | 2000 | 1000 | 0.5 | 20 | 50 | 1000 |
| Sample 102 | 100 | 33 | 2000 | 500 | 0.3 | 18 | 45 | 810 |
| Sample 103 | 100 | 5 | 600 | 100 | 0.2 | 20 | 40 | 800 |
| Sample 104 | 150 | 10 | 3500 | 1500 | 0.4 | 20 | 70 | 1400 |
| Sample 105 | 150 | 20 | 1500 | 1000 | 0.7 | 25 | 55 | 1375 |

### [Discussion]

According to Table 1 and Table 2, beta-Ga₂O₃ single crystal substrates of samples 11 to 15, samples 21 to 25 and samples 31 to 33 showed a lower cracking defect rate than the beta-Ga₂O₃ single crystal substrates of samples 101 to 105. Furthermore, the beta-Ga₂O₃ single crystal substrates of samples 11 to 15, samples 21 to 25 and samples 31 to 33 showed a lower device yield index than the beta-Ga₂O₃ single crystal substrates of samples 101 to 105, and accordingly; it has been also suggested that the device yield is improved. The beta-Ga₂O₃ single crystal substrates of samples 31 to 33 exhibited an equivalent performance to that of beta-Ga₂O₃ single crystal substrates of samples 11 to 15 and samples 21 to 25, despite a fact that a time period from the end of raw material melting step S130 to the start of the Ga₂O₃ single crystal growing step S140 was short; and it has been suggested that the manufacturing efficiency can be improved.

The embodiments and the Examples of the present disclosure have been described as in the above, and it is also planned from the beginning to appropriately combine the above-mentioned configurations of the embodiments and the Examples.

The embodiments and the Examples disclosed herein should be considered in all respects illustrative and not restrictive. The scope of the present invention is defined by the claims rather than the above-described embodiments and Examples, and is intended to include all modifications within the scope and meaning equivalent to the claims.

### REFERENCE SIGNS LIST

1 beta-digallium trioxide single crystal substrate (beta-Ga₂O₃ single crystal substrate); 10 main surface; 11 first region; 12 second region; 13 boundary between first region and second region; 1a line-shaped hole; 2 bubble; 3 stirring rod; 4 hollow tube; 5 crucible; 51 seed-crystal accommodating portion; 52 diameter-increasing portion; 53 straight body portion; 6 crucible holding table; 7 heating apparatus; 8a seed crystal; 81 beta-digallium trioxide single crystal (beta-Ga₂O₃ single crystal); 82 Digallium trioxide melt (Ga₂O₃ melt); 9 pressure vessel; 100 single crystal growing apparatus; G grid; DL line for dividing into grid pattern; OF orientation flat; S100 beta-Ga₂O₃ single crystal manufacturing process; S110 preparing step; S120 raw material charging step; S130 raw material melting step; S140 Ga₂O₃ single crystal growing step; S200 beta-Ga₂O₃ single crystal substrate manufacturing process.

## Claims

1. A beta-digallium trioxide single crystal substrate comprising a circular main surface, wherein
the beta-digallium trioxide single crystal substrate has a diameter of 100 mm or more,
the main surface is a (001) plane of a beta-digallium trioxide single crystal constituting the beta-digallium trioxide single crystal substrate, or alternatively is a face having an off-angle of more than 0° and 10° or less from the (001) plane of the beta-digallium trioxide single crystal, and having an off-direction in a [010] direction of the beta-digallium trioxide single crystal or a direction orthogonal to the [010] direction,
second density/first density, which is a ratio between a first density that is a density of line-shaped holes in a circular first region having a diameter of a length of 0.75D centered at the center of the main surface, and a second density that is a density of line-shaped holes in a second region which is a region outside the first region on the main surface, is larger than 1.0,
the second density is 1000 cm⁻² or less,
the D represents a diameter of the beta-digallium trioxide single crystal substrate, and a unit of the D is mm,
the line-shaped hole has a length of 10 µm or more and 200 µm or less, a width of 0.01 µm or more and 2 µm or less, and a depth of 0.1 µm or more, and
the density of the line-shaped holes in the first region and the density of the line-shaped holes in the second region are each the number of the line-shaped holes per 1 cm², which is determined by forming a virtual grid in which squares each having a side of 10 mm are laid out so that the largest number of squares are arranged in parallel without overlapping with each other, on the main surface, and counting the number of the line-shaped holes present in each of the squares constituting the grid by using a differential interference microscope.

2. The beta-digallium trioxide single crystal substrate according to claim 1, wherein the second density is 1 cm⁻² or more and 100 cm⁻² or less.

3. The beta-digallium trioxide single crystal substrate according to claim 1 or claim 2, wherein the second density/first density is 2.5 or less.

4. The beta-digallium trioxide single crystal substrate according to any one of claim 1 to claim 3, wherein
the beta-digallium trioxide single crystal substrate further comprises a dopant,
the dopant is tin or silicon, and
an atomic concentration of the dopant is 5.0×10¹⁹ cm⁻³ or less.

5. A method for manufacturing a beta-digallium trioxide single crystal with use of a vertical boat method, comprising:
preparing a single crystal growing apparatus comprising at least a cylindrical crucible and a heating apparatus that is arranged so as to surround an outer periphery of the crucible;
accommodating a seed crystal in a bottom portion of the crucible, and accommodating a massive digallium trioxide bulk body in an upper portion above the seed crystal in the crucible;
heating the crucible with the heating apparatus to melt the digallium trioxide bulk body and a part of the seed crystal, thereby obtaining a digallium trioxide melt, and contacting the digallium trioxide melt with a remaining portion of the seed crystal; and
obtaining the beta-digallium trioxide single crystal by growing a crystal on the remaining portion of the seed crystal from the digallium trioxide melt, wherein
the crucible is formed from a platinum-rhodium alloy, and
the obtaining of the beta-digallium trioxide single crystal comprises inserting a stirring rod formed from a platinum-rhodium alloy into the digallium trioxide melt and growing the crystal while stirring the digallium trioxide melt with the stirring rod.

6. A method for manufacturing a beta-digallium trioxide single crystal with use of a vertical boat method, comprising:
preparing a single crystal growing apparatus comprising at least a cylindrical crucible and a heating apparatus that is arranged so as to surround an outer periphery of the crucible;
accommodating a seed crystal in a bottom portion of the crucible, and accommodating a massive digallium trioxide bulk body in an upper portion above the seed crystal in the crucible;
heating the crucible with the heating apparatus to melt the digallium trioxide bulk body and a part of the seed crystal, thereby obtaining a digallium trioxide melt, and contacting the digallium trioxide melt with a remaining portion of the seed crystal; and
obtaining the beta-digallium trioxide single crystal by growing a crystal on the remaining portion of the seed crystal from the digallium trioxide melt, wherein
the crucible is formed from a platinum-rhodium alloy, and
the obtaining of the beta-digallium trioxide single crystal comprises inserting a hollow tube formed from a platinum-rhodium alloy into the digallium trioxide melt and growing the crystal while blowing an inert gas into the digallium trioxide melt through the hollow tube.

7. The method for manufacturing the beta-digallium trioxide single crystal according to claim 6, wherein the obtaining of the beta-digallium trioxide single crystal comprises stirring the digallium trioxide melt with the hollow tube.

8. The method for manufacturing the beta-digallium trioxide single crystal according to any one of claim 5 to claim 7,
wherein the single crystal growing apparatus is accommodated in a pressure vessel; and
the method further comprises repeating an operation of reducing a pressure in the pressure vessel from 1 atm and then returning the pressure to the 1 atm, three or more times, after contacting the digallium trioxide melt with the remaining portion of the seed crystal and before obtaining the beta-digallium trioxide single crystal.

9. A method for manufacturing a beta-digallium trioxide single crystal substrate, comprising processing the beta-digallium trioxide single crystal obtained by the method for manufacturing the beta-digallium trioxide single crystal according to any one of claim 5 to claim 8 to obtain the beta-digallium trioxide single crystal substrate having a circular main surface.

10. The beta-digallium trioxide single crystal substrate according to claim 1, wherein
the second density is 1 cm⁻² or more and 90 cm⁻² or less,
the second density/first density is 1.1 or more and 2 or less,
the beta-digallium trioxide single crystal substrate comprises a dopant,
the dopant is tin, and
an atomic concentration of the dopant is 5.0×10¹⁹ cm⁻³ or less.
